Europäisches Patentamt

European Patent Office

Office européen des brevets

(19)

(11) Veröffentlichungsnummer : **0 363 714 B1**

(12) # EUROPÄISCHE PATENTSCHRIFT

(45) Veröffentlichungstag der Patentschrift :
**05.04.95 Patentblatt 95/14**

(51) Int. Cl.⁶ : **H03G 9/02,** H03G 9/12,
H04R 25/00, H03G 7/08

(21) Anmeldenummer : **89117648.9**

(22) Anmeldetag : **25.09.89**

(54) Integrierter Kompressionsverstärker mit programmierbarer Schwellspannung.

(30) Priorität : **13.10.88 DE 3834928**

(43) Veröffentlichungstag der Anmeldung :
**18.04.90 Patentblatt 90/16**

(45) Bekanntmachung des Hinweises auf die
Patenterteilung :
**05.04.95 Patentblatt 95/14**

(84) Benannte Vertragsstaaten :
**AT CH DE FR GB IT LI NL**

(56) Entgegenhaltungen :
**US-A- 3 919 654**
**US-A- 4 539 440**

(56) Entgegenhaltungen :
**AES AN AUDIO ENGINEERING SOCIETY PRE-
PRINT PRESENTED AT THE 35TH CONVEN-
TION,21th-24th October 1968, preprint no. 602
(K-10) AES, New York, US; B. Blesser et al.:" A
New Approach to Dynamic Range Compression for Audio Systems";
IEEE JOURNAL OF SOLID-STATE CIRCUITS.
vol. sc-11, no. 6, Dezember 1976, NEW YORK
US, Seiten 754-762; C. C. Todd: "A Monolithic
Analog Compandor"
ELECTRONICS LETTERS. vol. 17, no. 4, 19
Februar 1981, ENAGE GB Seiten 160 -162; F.
Krummenacher: "High Voltage Gain CMOS
OTA for Micropower SC Filters"**

(73) Patentinhaber : **SIEMENS
AKTIENGESELLSCHAFT
Wittelsbacherplatz 2
D-80333 München (DE)**

(72) Erfinder : **Mauthe, Manfred, Dipl.-Ing.
Kranichweg 34
D-8000 München 82 (DE)**

## Beschreibung

Die Erfindung betrifft einen integrierten Kompressionsverstärker mit programmierbarer Schwellspannung nach dem Oberbegriff des Patentanspruches 1 sowie nach dem Oberbegriff des Patentanspruches 6.

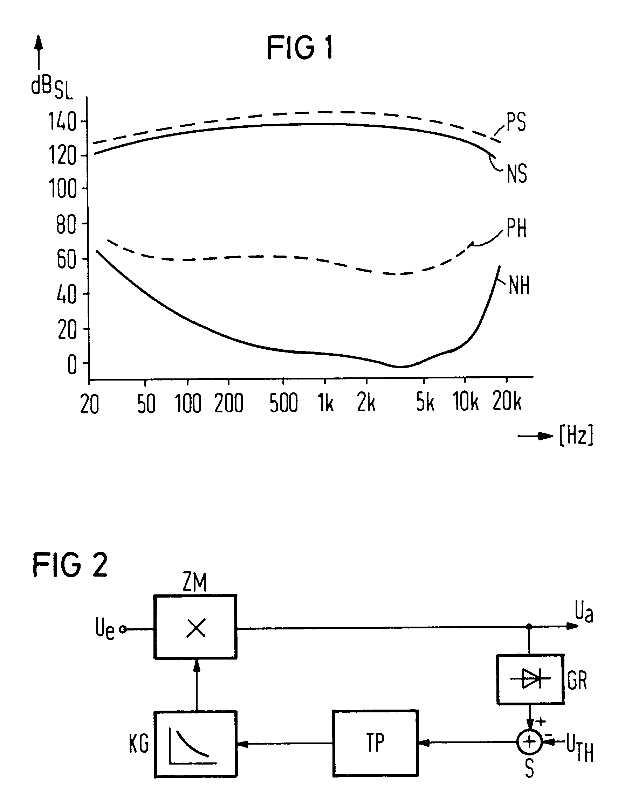

Hörschäden, bei denen der Dynamikbereich eingeschränkt ist, bezeichnet man als Rekruitment. Mit einer Schaltung, die die Verstärkung regelt, kann man diesen Schaden ausgleichen. Man benötigt hierzu eine AGC-Schaltung (automatic gain control) oder genauer ausgedrückt, einen Kompressionsverstärker. Figur 1 zeigt die Hör- und Schmerzwelle eines Normalhörenden sowie eines Hörgeschädigten. Hierfür ist auf der Abszisse die Frequenz f in Herz und auf der Ordinate der Schalldruckpegel in db aufgetragen. Der Dynamikbereich eines Normalhörenden beginnt bei der normalen Hörschwelle NH und endet mit der normalen Schmerzschwelle NS, während der eingeschränkte Dynamikbereich des Rekruitments zwischen der pathologischen Hörschwelle PH und der pathologischen Schmerzschwelle PS liegt. Hier liegt also die pathologische über der normalen Hörschwelle. In einem solchen Fall werden die Töne, die von einem Normalhörenden noch wahrgenommen werden, nicht mehr gehört. Wenn die Schmerzgrenze in etwa erhalten bleibt, ist der Dynamikbereich gegenüber dem normalen eingeschränkt. Oder anders ausgedrückt, der normale Dynamikbereich der Sprache wird auf den pathologischen Dynamikbereich des Hörgeschädigten zusammengedrückt. Um das Rekruitment zu kompensieren und dem Geschädigten den Eindruck eines Normalhörenden zu verleihen, müssen leise Töne um einen hohen Betrag und lautere Töne um einen niederen Betrag zur Hörschwelle verstärkt werden. Eine hierzu notwendige amplitudenabhängige Verstärkung wird mit einem Kompressionsverstärker erzielt. Diese werden in Hörgeräte eingesetzt um das Rekruitment auszugleichen. Bei einem Kompressionsverstärker ist die Verstärkung bis zu einer einstellbaren Schwelle konstant. Für Eingangspegel, die über dem Schwellwert liegen, nimmt die Verstärkung ab. Das Kompressionsverhältnis $K_v$ ist der Quotient aus Ausgangspegeländerung zu Eingangspegeländerung. Üblicherweise liegt das Kompressionsverhältnis zwischen 1/5 und 1/12. Die Kompressionskennlinie des Kompressionsverstärkers zeigt bis zu einer einstellbaren Schwelle die konstante Verstärkung 1. Oberhalb dieser Schwelle setzt die Kompression ein und der Verstärkungsfaktor definiert als

$$V_u\,(U_e)\;=\;(\frac{U_e}{U_{eth}})^{-\,(1\,-\,K_v)}$$

mit $U_e$ = Eingangsspannung und $U_{eth}$ = einstellbarer Schwellspannung nimmt mit einem hyperbelförmigen Verlauf ab.

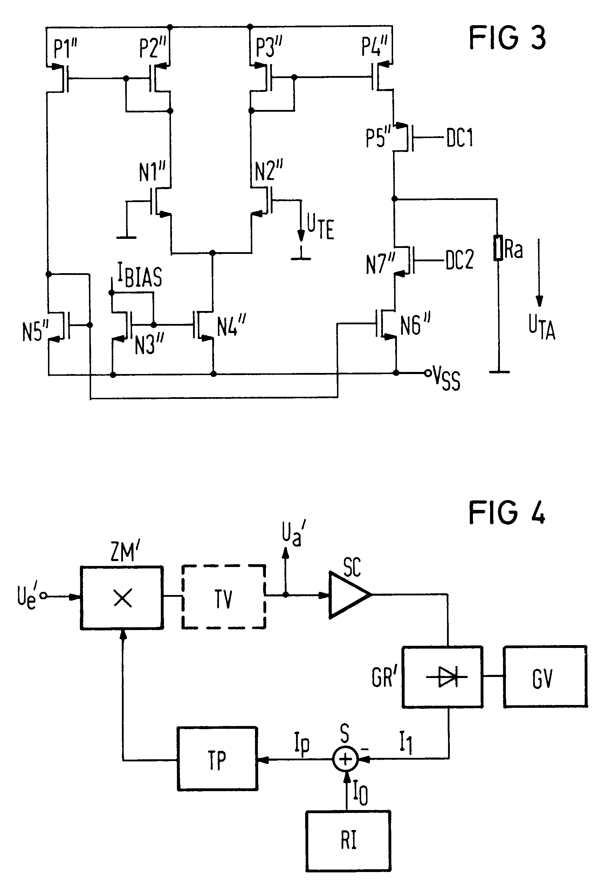

Kompressionsverstärker für niedrige Versorgungsspannungen in Bipolartechnologie sind Stand der Technik, wobei es sich im wesentlichen hierbei um rückgekoppelte Verstärker handelt, deren Verstärkung von der Ausgangsamplitude geregelt wird. Ein Blockschaltbild hierzu zeigt Figur 2. Mit einem Detektor wird die Ausgangsamplitude ermittelt und durch einen Tiefpaß die Regelspannung erzeugt. Das Eingangssignal wird in einem Zweiquadrantenmultiplizierer mit der von der Regelspannung abhängigen Verstärkung multipliziert. Zweiquadrantenmultiplizierer in Bipolartechnik sind in der Veröffentlichung von Jung, W. G.: "Get gain control of 80 to 100 dB", Electronic Design 13, June 21, 1974, Seite 94 bis 99, wieder zu finden. Als besondere Realisierungsform für einen Zweiquadrantenmultiplizierer kann ein Transkonduktanzverstärker nach Figur 3 gewählt werden. Aus der Literatur sind Transkonduktanzverstärker in CMOS-Technik bekannt und beschrieben bei Krummenacher, F.: "High voltage gain CMOS OTA for micropower SC-Filters", Electronic Letters, Februar 19, 1981, Volume 17, Nr. 4, Seiten 160 bis 162. Arbeiten die Eingangstransistoren in schwacher Inversion, der einem Grenzzustand zwischen Sperren und Leiten gleichkommt, so läßt sich die Verstärkung des Transkonduktanzverstärkers proportional zum Eingangsstrom (Biasstrom) verändern. Um am Ausgang als Signal am Transkonduktanzverstärker wieder eine Spannung zur Verfügung zu haben wird der Verstärker mit einem Widerstand Ra abgeschlossen. Da die Ströme hier in der Größenordnung von Mikroampere liegen, ist der Ausgangswiderstand Ra im Bereich 1 - 10 MOhm zu wählen.

Bei einem Hörschaden muß der Dynamikbereich nicht unbedingt über den gesamten hörenden Frequenzbereich eingeschränkt sein. Beispielsweise ist ein Rekruitment im unteren und oberen Frequenzbereich denkbar, während im mittleren Frequenzbereich der Dynamikbereich nicht eingeschränkt ist. Um solche Hörschäden besser zu kompensieren wurden Mehrkanal-AGC-Geräte entwickelt, wobei jeder Kanal für ein bestimmtes Frequenzband zuständig ist. Gegenwärtig könnte ein Mehrkanal-AGC-Gerät in gemischter Technologie (Bipolar-CMOS-Technk) durch eine Mehrchipschaltung realisiert werden. Eine solche Lösung ist aber wegen des notwendigen Raumbedarfs für ein Hinterohrgerät nicht akzeptabel.

Aus dem AES PREPRINT PRESENTED AT THE 35TH CONVENTION, 21. - 24. Oktober 1968, preprint no. 602 (K-10), AES, New York, US von B. Blesser et al. zum Thema "A New Approach to Dynamic Range Compression for Audio Systems" ist eine Anordnung zur Minimierung des subjektiven Rauschempfindens bekannt, bei dem ein Mulitplizierer zur Erreichung einer variablen Verstärkung vorgesehen ist, der das der Reihe nach über eine Gleichrichtungseinheit, eine Mittelwertbildungseinheit und Summationseinheiten rückgekoppelte Ausgangssignal mit dem Eingangssignal der Anordnung multipliziert, wobei den Summationseinheiten Signale aus einer Expandereinheit und einer Begrenzer-Einheit zugeführt werden.

Aus der US-Patentschrift 3.919.654 ist ein Dynamik-Kompressor bekannt, der in der Signalübertragung zur Rauschunterdrückung bei kleinen Signalamplituden verwendet wird und der zwei Verstär-kerstufen zwischen Signaleingang und Signalausgang aufweist, zwischen denen das durch einen Transkonduktanzverstärker rückgekoppelte Ausgangssignal eingekoppelt wird, wobei der Transkonduktanzverstärker durch eine Stromquelle versorgt wird, die durch das gleichgerichtete und durch einen Tiefpaß geglättete Ausgangssignal des Kompressors angesteuert wird.

Der Erfindung liegt die Aufgabe zugrunde einen Kompressionsverstärker in CMOS-Technologie anzugeben, der mit niederer Spannung betrieben werden kann und dessen Schaltung integrierbar ist und somit möglichst wenig Platz beansprucht.

Diese Aufgabe wird erfindungsgemäß durch den kennzeichnenden Teil des Patentanspruches 1 gelöst.

Der mit der Erfindung erzielbare Vorteil besteht insbesondere darin, daß der Kompressionsverstärker auf einem Chip zusammen mit einem SC-Filter (switched capacitor filter) in CMOS-Technologie integrierbar ist und hierdurch die Möglichkeit gegeben ist ein Mehrkanal-AGC-Gerät zu realisieren. Die Schwellspannung, ab der die Kompression einsetzen soll, ist beim erfindungsgemäßen Kompressionsverstärker in diskreten Stufen wählbar und wird bei der Betriebsaufnahme durch eine Programmierung festgelegt.

Die Ansprüche 2 bis 5 und 7 bis 18 sind auf bevorzugte Ausgestaltungen und Anspruch 19 ist auf eine bevorzugte Verwendung des erfindungsgemäßen Kompressionsverstärkers gerichtet.

Die Erfindung wird nachfolgend anhand von Zeichnungen näher erläutert. Dabei zeigen:

Figur 1    die bereits in der Einleitung beschriebene Hör- und Schmerzschwelle eines Normalhörenden und eines Hörgeschädigten, über einen Frequenzbereich von 20 Hz - 20 kHz,

Figur 2    das Blockschaltbild eines Kompressionsverstärkers nach dem Stand der Technik,

Figur 3    ein Transkonduktanzverstärker nach dem Stand der Technik,

Figur 4    ein Blockschaltbild des erfindungsgemäßen Kompressionsverstärkers mit einem konstanten Ausgangspegel für sehr hohe Eingangspegel,

Figur 5    die Realisierung des erfindungsgemäßen Kompressionsverstärkers nach dem Blockschaltbild aus Figur 4,

Figur 6    die Realisierung einer Referenzvorspannungsquelle, die zum Betrieb des erfindungsgemäßen Kompressionsverstärkers nach Figur 5 notwendig ist,

Figur 7    ein Blockschaltbild eines erfindungsgemäßen Kompressionsverstärkers, dessen Ausgangspegel nach Überschreiten einer Schwellspannung mit wachsenden Eingangspegel geringer ansteigt,

Figur 8    eine Realisierung des erfindungsgemäßen Kompressionsverstärkers nach dem Blockschaltbild Figur 7,

Figur 9    eine Realisierung einer Referenzspannungsquelle zum Betrieb des erfindungsgemäßen Kompressionsverstärkers nach Figur 8.

Figur 2 zeigt einen Kompressionsverstärker nach dem Stand der Technik mit einem Zweiquadrantenmultiplizierer ZM und einem Rückkopplungszweig. Der Zweiquadrantenmulitplizierer ZM ist zwischen dem Ein- und Ausgang $U_e$, $U_a$ des Kompressionsverstärkers geschaltet, während der Rückkopplungszweig zwischen dem Ausgang $U_a$ des Kompressionsverstärkers und einem Steuereingang des Zweiquadrantenmulitplizierers ZM angeordnet ist. Der Rückkopplungszweig enthält eine Gleichrichterstufe GR, einen Tiefpaß TP, sowie ein Kennlinienglied KG. Das Ausgangssignal am Ausgang $U_a$ des Kompressionsverstärkers wird über die Gleichrichterstufe GR an einem Summationspunkt S mit einer Schwellspannung $U_{TH}$ verglichen. Ein sich hierbei ergebendes Signal wird über den Tiefpaß TP als Regelspannung dem Kennlinienglied KG zugeführt. Über das Kennlinienglied KG wird anschließend die benötigte Verstärkung v ermittelt und auf den Zweiquadrantenmultiplizierer rückgekoppelt. Wie aus der Figur 2 im Kennlinienglied KG ersichtlich, hat die Verstärkungskennlinie den eingangs bereits erwähnten hyperbelförmigen Verlauf, die ab der Schwellspannung einsetzen soll. Erreicht das gleichgerichtete Ausgangssignal des Kompressionsverstärkers nicht die Schwellspannung $U_{TH}$, so liefert der Kompressionsverstärker eine Verstärkung von v = 1, wobei die Rückkopplung über den Rückkopplungszweig unwirksam ist. Überschreitet das gleichgerichtete Ausgangssignal des Kompressionsverstärkers den Schwellwert $U_{TH}$ setzt die Kompressionswirkung ein und über den Rückkopplungszweig wird die gewünschte Verstärkung eingestellt.

Für einen Zweiquadrantenmultiplizier kann in einer besonderen Realisierungsform ein sogenannter Transkonduktanzverstärker eingesetzt werden, wie er beispielsweise in der Figur 3 dargestellt ist. Zu dem Aufbau dieses Transkonduktanzverstärkers wird eine Differenzstufe sowie vier Stromspiegelschaltungen benötigt. Die erste Stromspiegelschaltung wird hierbei auf den gemeinsamen ersten Anschluß der beiden n-Kanal-Feldeffekttransistoren N1″, N2″ geschaltet, während die restlichen drei Stromspiegelschaltungen am Ausgang des Differenzverstärkers angeordnet sind. Zwei der drei Stromspiegelschaltungen sind hierbei in Serie geschaltet am Ausgang des ersten n-Kanal-Feldeffekttransistors N1″, während die dritte Stromspiegelschaltung am Ausgang des zweiten n-Kanal-Feldeffekttransistors N2″ angeschlossen ist. Über je einen p- und n-Kanal-Feldeffekttransistor werden die beiden aus dem Differenzverstärker verstärkten Stromanteile auf einen gemeinsamen Ausgang geführt, wobei über den angeschlossenen Ausgangswiderstand $R_a$ die Ausgangsspannung $U_{TA}$ abfällt. Wie bereits eingangs angegeben wird der Ausgangswiderstand $R_a$ im Bereich von 1 bis 10 MOhm gewählt, da die auftretenden Ströme hierbei in der Größenordnung von μ-Ampere liegen.

Im einzelnen ist der Transkonduktanzverstärker nach Figur 3 wie folgt aufgebaut. Die ersten beiden Anschlüsse des ersten und zweiten n-Kanal-Feldeffekttransistors N1″, N2″ sind gemeinsam auf den Ausgang der ersten Stromspiegelschaltung geschaltet, die mit Hilfe eines dritten und vierten n-Kanal-Feldeffekttransistors N3″, N4″ aufgebaut ist. Über den Steuereingang, der nach dem Blockschaltbild des Kompressionsverstärkers in Figur 2 als Rückkopplungseingang eingesetzt wird, wird der Steuerstrom $I_{BIAS}$ auf den ersten Anschluß und den Gateanschluß des dritten n-Kanal-Feldeffekttransistors N3″ sowie auf den Gateanschluß des vierten n-Kanal-Feldeffekttransistors N4″ geschaltet. Der zweite Anschluß des dritten und vierten n-Kanal-Feldeffekttransistors N3″, N4″ sind auf $V_{SS}$ gelegt, während der erste Anschluß des vierten n-Kanal-Feldeffekttransistors N4″ den Ausgang der ersten Stromspiegelschaltung darstellt. Der Gateanschluß des ersten n-Kanal-Feldeffekttransistros N1″ wird in der Schaltung nach Figur 3 auf Masse GND gelegt, während am Gateanschluß des zweiten n-Kanal-Feldeffekttransistors N2″ die Eingangsspannung $U_{TE}$ anliegt. Der zweite Anschluß des ersten n-Kanal-Feldeffekttransistors N1″, der den ersten Ausgang des Differenzverstärkers bildet, ist auf die zweite Stromspiegelschaltung, bestehend aus den beiden p-Kanal-Feldeffekttransistoren P1″, P2″ geschaltet. Hierzu ist der erste Anschluß und der Gateanschluß des zweiten p-Kanal-Feldeffekttransistors P2″, sowie der Gateanschluß des ersten p-Kanal-Feldeffekttransistors P1″ gemeinsam mit dem ersten Ausgang des Differenzverstärkers verbunden, während der erste Anschluß des ersten p-Kanal-Feldeffekttransistors P1″ den Ausgang der zweiten Stromspiegelschaltung darstellt. Der zweite Anschluß des zweiten n-Kanal-Feldeffekttransistors N2″ des Differenzverstärkers ist über den Gateanschluß des dritten p-Kanal-Feldeffekttransistors P3″, den Gateanschluß des vierten p-Kanal-Feldeffekttransistors P4″ sowie mit dem ersten Anschluß des dritten p-Kanal-Feldeffekttransistors P3″ verschaltet, wobei der dritte und vierte p-Kanal-Feldeffekttransistor P3″, P4″ die dritte Stromspiegelschaltung bilden. Weiterhin ist die zweite und dritte Stromspiegelschaltung über jeweils den zweiten Anschluß des ersten und zweiten p-Kanal-Feldeffekttransistors P1″, P2″ und jeweils des zweiten Anschlusses des dritten und vierten p-Kanal-Feldeffekttransistors P3″, P4″ untereinander verbunden. Der Ausgang der zweiten Stromspiegelschaltung ist auf die aus den fünften und sechsten n-Kanal-Feldeffekttransistor N5″, N6″ bestehende vierte Stromspiegelschaltung aufgeschaltet. Hierzu ist der Ausgang der zweiten Stromspiegelschaltung mit dem ersten Anschluß und dem Gateanschluß des fünften n-Kanal-Feldeffekttransistors N5″ sowie mit dem Gateanschluß des sechsten n-Kanal-Feldeffekttransistors N6″ verschaltet, während der zweite Anschluß des fünften n-Kanal-Feldeffekttransistors N5″ und der zweite Anschluß des sechsten n-Kanal-Feldeffekttransistros N6″ mit $V_{SS}$ verbunden ist. Der Ausgang der vierten Stromspiegelschaltung, die mit dem zweiten Anschluß des sechsten n-Kanal-Feldeffekttransistors N6″ gebildet wird, ist über einen siebten n-Kanal-Feldeffekttransistor N7″ mit dem Ausgang des Transkonduktanzverstärkers verbunden, während der Ausgang der dritten Stromspiegelschaltung, gebildet mit Hilfe des zweiten Anschlusses des vierten p-Kanal-Feldeffekttransistors P4″, über den fünften p-Kanal-Feldeffekttransistor P5″ ebenfalls an den Ausgang des Transkonduktanzverstärkers angeschlossen ist. In der gezeigten Schaltung nach Figur 3 ist wie bereits eingangs erwähnt am Ausgang des Transkonduktanzverstärkers ein Ausgangswiderstand Ra angeschlossen, über den die Ausgangsspannung $U_{TA}$ abfällt. Zum Einstellen des Arbeitpunkts des Transkonduktanzverstärkers wird auf den Gateanschluß des fünften p-Kanal-Feldeffekttransistros P5″ eine erste Hilfsspannung DC1 und über den Gateanschluß des siebten Feldeffekttransistors N7″ eine zweite Hilfsspannung DC2 angeschlossen. Wie bereits eingangs angegeben läßt sich bei diesem Transkonduktanzverstärker die Verstärkung proportional zum Steuerstrom $I_{BIAS}$ verändern, und so die Amplitude am Ausgang des Transkonduktanzverstärkers regeln.

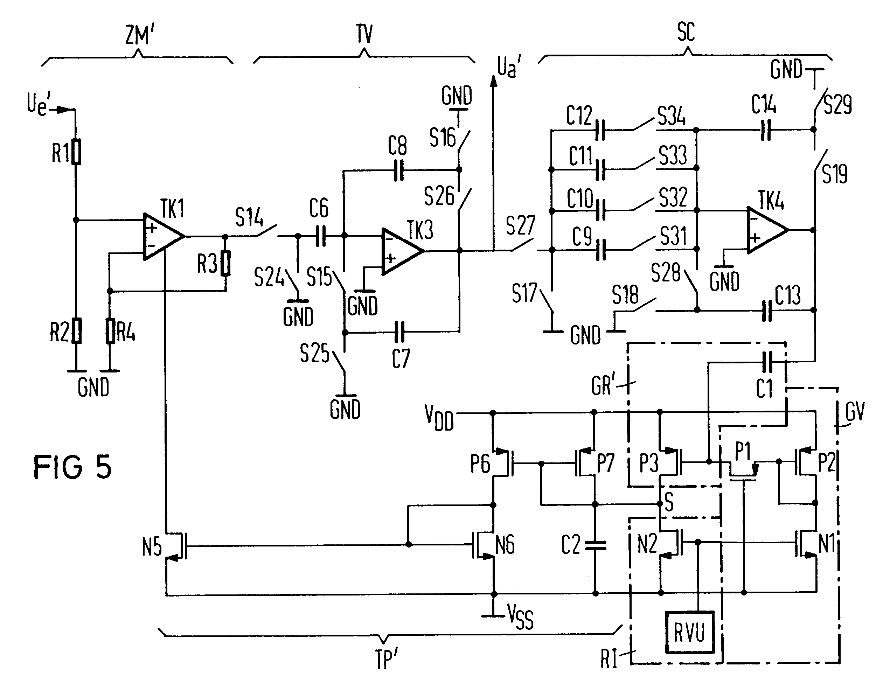

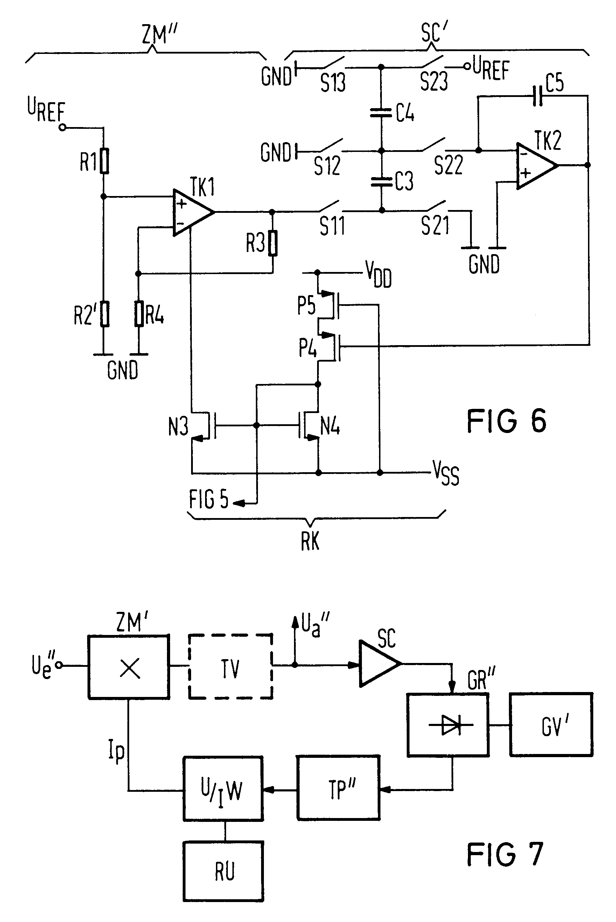

Figur 4 zeigt ein Blockschaltbild des erfindungsgemäßen Kompressionsverstärkers, der in seiner Realisierung nach Figur 5 und Figur 6 in CMOS-Technologie, aufgebaut werden kann. Die Ausgangskennlinien am Ausgang $U_a$ des erfindungsgemäßen Kompressionsverstärkers nähern sich für große Eingangspegel am Eingang $U_{e'}$ einem konstanten Ausgangspegel. Der Kompressionsverstärker nach Figur 4 enthält ebenfalls einen Zweiquadrantenmultiplizierer ZM′, dessen Eingang auch der Eingang des Kompressionsverstärkers $U_{e'}$ darstellt. Damit der geregelte Zweiquadrantenmultiplizierer eine konstante Ausgangslast sieht, folgt ein Trennverstärker TV, dessen Ausgang auch den Ausgang $U_{a'}$ des Kompressionsverstärkers darstellt. In der Figur 4 ist der Trennverstärker TV gestrichelt eingezeichnet, da er bei einer geeigneten Realisierung des Zweiquadrantenmulitplizierers ZM′ nicht erforderlich ist. Der Rückkopplungszweig des Kompressionsverstärkers nach Figur 4 enthält einen Verstärker mit veränderbarer Verstärkung SC, eine Gleichrichterstufe GR′ mit zugeordneter Vorspannungserzeugung GV, sowie einen Tiefpaß TP', dessen Ausgang auf den Zweiquadrantenmulitplizierer ZM' rückgekoppelt ist. Im einzelnen ist der Ausgang des Trennverstärkers TV bzw. der Ausgang des Zweiquadrantenmulitplizierers ZM' über den Verstärker mit veränderbarer Verstärkung SC mit dem Eingang der Gleichrichterstufe GR' verbunden. Um die Gleichrichterwirkung zu erreichen wird der Gleichrichterstufe GR' über eine angeschlossene Schaltung zur Vorspannungserzeugung GV eine Einsatzspannung zugeführt. Die Gleichrichterstufe setzt die um den Faktor $\alpha$ verstärkte Ausgangsspannung in einen mittleren Strom $I_1$ um, von dem an einem Summationspunkt S der konstante Strom $I_0$ subtrahiert wird. Hierzu ist der Ausgang der Gleichrichterstufe GR', die ein Stromsignal $-I_1$ liefert und der Ausgang einer Referenzstromquelle RI, die einen konstanten Strom $I_0$ erzeugt mit dem Summationspunkt S verbunden. Als Folge hiervon wird am Summationspunkt ein Steuerstrom $I_P$ ermittelt, der dem Tiefpaß TP' zugeführt wird. Die Größe des Stroms $I_0$ wird so gewählt, daß für den Strom $I_1 = 0$, dies entspricht dem Zustand der ausgeschalteten Kompression, die Verstärkung des Kompressionsverstärkers gerade 1 ist. Eine Zunahme des Ausgangspegels erzeugt dann einen größeren Strom $I_1$ und führt zu einer Abnahme des Steuerstroms IP. Hierdurch wird die Verstärkung reduziert und die Kompression setzt in einem stärkeren Maß ein. In der Realisierung nach Figur 5 verstärkt der Verstärker SC das rückgekoppelte Signal um den Wert $\alpha$ und ermöglicht hiermit eine Änderung der Schwellspannung, ab welcher die Kompression einsetzt. Für eine Realisierung des Zweiquadrantenmulitplizierers ZM' im Blockschaltbild nach Figur 4 ist ebenfalls ein Transkonduktanzverstärker nach Figur 3 einsetzbar.

Für große Eingangspegel nähern sich wie bereits angegeben die Ausgangskennlinien dieses Kompressionsverstärkers einem konstanten Ausgangspegel. Dies rührt daher, daß der Steuerstrom $I_P$ immer stärker, und zwar quadratisch mit der Ausgangsspannung am Ausgang $U_a'$ abnimmt. In den folgenden Figuren, Figur 5 und Figur 6 wird eine Realisierung auf Transistorebene für den erfindungsgemäßen Kompressionsverstärker nach Figur 4 angegeben.

In Figur 5 sind nochmals alle Einzelkomponenten des Blockschaltbildes zum erfindungsgemäßen Kompressionsverstärkers eingezeichnet. Hierzu gehört im Rückkopplungszweig der Verstärker mit variabler Verstärkung SC, die Gleichrichterstufe GR' mit zugehöriger Schaltung zur Vorspannungserzeugung GV, die Referenzstromquelle RI sowie der Tiefpaß TP'.

Im einzelnen enthält die Schaltung zur Vorspannungserzeugung einen ersten n-Kanal-Feldeffekttransistor N1 und einen ersten und zweiten p-Kanal-Feldeffekttransistor P1, P2. Ein Gateanschluß des ersten p-Kanal-Feldeffekttransistors P1 und ein erster Anschluß des ersten n-Kanal-Feldeffekttransistors N1 sind gemeinsam auf eine negative Versorgungsspannung $V_{SS}$, geschaltet, und ein zweiter Anschluß des ersten n-Kanal-Feldeffekttransistors N1 und ein erster Anschluß des zweiten n-Kanal-Feldeffekttransistors P2 sind gemeinsam mit einem Gateanschluß des zweiten p-Kanal-Feldeffekttransistors P2 und einem ersten Eingang des ersten p-Kanal-Feldeffekttransistors P1 verschaltet. Ein zweiter Anschluß des zweiten p-Kanal-Feldeffekttransistors P2 ist mit einer positiven Versorgungsspannung $V_{DD}$ und ein zweiter Anschluß des ersten p-Kanal-Feldeffekttransistors P1 mit der Gleichrichterstufe GR' verbunden.

Die Referenzstromquelle RI enthält eine Referenzvorspannungsschaltung, in Figur 5 mit RVU bezeichnet, und einen zweiten n-Kanal-Feldeffekttransistor N2, wobei der erste Eingang des zweiten n-Kanal-Feldeffekttransistors N2 mit der negativen Versorgungsspannung $V_{SS}$ und ein zweiter Eingang des zweiten n-Kanal-Feldeffekttransistors N2, der den Ausgang der Referenzstromquelle bildet und den konstanten Strom $I_0$ liefert, ist mit dem Summationspunkt S verbunden. Der Gateanschluß des ersten n-Kanal-Feldeffekttransistors N1 und der Gateanschluß des zweiten n-Kanal-Feldeffekttransistors N2 ist weiterhin mit der Referenzvorspannungsschaltung RVU verschaltet, dessen Realisierung in Figur 6 zu entnehmen ist.

Die zum Rückkopplungszweig gehörende Gleichrichterstufe GR' enthält einen dritten p-Kanal-Feldeffekttransistor P3 und eine erste Kapazität C1, wobei die erste Kapazität C1 zwischen dem Ausgang des Verstärkers mit veränderbarer Verstärkung SC und dem Gateanschluß des dritten p-Kanal-Feldeffekttransistors, sowie mit dem zweiten Anschluß des ersten p-Kanal-Feldeffekttransistors P1 aus der Schaltung zur Vorspannungserzeugung geschaltet ist. Weiterhin ist ein erster Anschluß des dritten p-Kanal-Feldeffekttransistors P3 mit der positiven Versorgungsspannung $V_{DD}$ und ein zweiter Anschluß des dritten p-Kanal-Feldeffekttransistors P3, der den Ausgang der Gleichrichterstufe GR' bildet und den Strom $-I_1$ liefert, ist mit dem Summationspunkt S verbunden. Um die Gleichrichterwirkung zu erreichen, wird der Gateanschluß des dritten p-Kanal-Feldeffekttransistors P3 mit einer Einsatzspannung vorgespannt. Für positive Halbwellen, die als Eingangssignal über den ersten Kondensator C1 zugeführt werden, sperrt der dritte p-Kanal-Feldeffekttransistor P3. Für negative Halbwellen wirkt der dritte p-Kanal-Feldeffekttransistor P3 als Stromquelle mit einer quadratischen Stromkennlinie eines MOS-Transistors.

Der Tiefpaß TP', über dessen Eingang der Steuerstrom $I_P$ vom Summationspunkt S eingespeist wird, enthält einen fünften und sechsten n-Kanal-Feldeffekttransistor N5, N6, einen sechsten und siebten p-Kanal-Feldeffekttransistor P6, P7 sowie eine zweite Kapazität C2. Hierbei bildet der fünfte und sechste n-Kanal-Feldeffekttransistor N5, N6 sowie der sechste und siebte p-Kanal-Feldeffekttransistor P6, P7 je eine Stromspiegelschaltung über die der Strom $I_P$ nach einer zeitlichen Mittelung mit Hilfe der zweiten Kapazität C2 in die Differenzstufe des Transkonduktanzverstärkers TK1 eingespeist wird. Im einzelnen ist ein erster Eingang des sechsten p-Kanal-Feldeffekttransistors P6 und ein erster Eingang des siebten p-Kanal-Feldeffekttransistors P7 an die positive Versorgungsspannung $V_{DD}$ angeschlossen und ein erster Anschluß des fünften n-Kanal-Feldeffekttransistors N5 und ein erster Anschluß des sechsten n-Kanal-Feldeffekttransistors N6 ist mit der negativen Versorgungsspannung $V_{SS}$ verbunden. Ein Gateanschluß des fünften n-Kanal-Feldeffekttransistors N5, ein Gateanschluß des sechsten n-Kanal-Feldeffekttransistors N6 ist darüber hinaus gemeinsam mit einem zweiten Anschluß des sechsten p-Kanal-Feldeffekttransistors P6 und einem zweiten Anschluß des sechsten n-Kanal-Feldeffekttransistors N6 verschaltet. Der Ausgang des Tiefpasses TP' wird durch einen zweiten Anschluß des fünften n-Kanal-Feldeffekttransistors N5 gebildet, während die zweite Kapazität C2 zwischen der negativen Versorgungsspannung $V_{SS}$ und einem zweiten Anschluß des siebten p-Kanal-Feldeffekttransistors P7 verschaltet ist. Zusätzlich ist der zweite Anschluß des siebten p-Kanal-Feldeffekttransistors P7, der den Eingang des Tiefpasses TP' bildet, mit dem Summationspunkt S, mit einem Gateanschluß des sechsten und einem Gateanschluß des siebten p-Kanal-Feldeffekttransistors P6, P7 verschaltet.

Weiterhin weist der integrierte Kompressionsverstärker nach Figur 5 einen geregelten Transkonduktanzverstärker TK1 auf, der ein wesentlicher Bestandteil des Zweiquadrantenmultiplizierers ZM' darstellt. Ein Eingangssignal am Eingang $U_{e'}$ des Zweiquadrantenmulitplizierers ZM' wird über einen vorgeschalteten Spannungsteiler, bestehend aus R1 und R2 gedämpft, um eine Übersteuerung des ersten Einganges des Transkonduktanzverstärkers TK1 zu verhindern. Ausgangsseitig ist der Transkonduktanzverstärker TK1 mit einem dritten und vierten Widerstand R3, R4 abgeschlossen. Die Widerstände R1 bis R4 können als Bahnwiderstände aus hochohmigem Polysilizium oder mit Hilfe schwach dotierter p-Wannen ausgeführt werden, eine Realisierung durch geschaltete Kapazitäten ist hierbei ebenfalls denkbar. Die Realisierung der Widerstände aus hochohmigem Polysilizium oder mit Hilfe schwach dotierter p-Wannen hat jedoch den Vorteil, daß zusätzlich eingekoppelte Takte den Betrieb des Transkonduktanzverstärkers nicht beeinträchtigen. Im einzelnen bildet der erste und zweite Widerstand R1, R2 den vorgeschalteten Spannungsteiler, der zwischen dem Eingang des Zweiquadrantenmultiplizierers ZM' und Masse GND verschaltet ist. Ein erster Eingang des ersten Transkonduktanzverstärkers TK1 ist mit dem Spannungsteiler über einen Mittenabgriff zwischen dem ersten und zweiten Widerstand R1, R2 angeschlossen, während der zweite Eingang desselbigen über einen vierten Widerstand R4 mit Masse GND verbunden ist. Zusätzlich ist der zweite Eingang des ersten Transkonduktanzverstärkers TK1 über den dritten Widerstand R3 mit dem Ausgang des Zweiquadrantenmultiplizierers ZM' und mit dem Ausgang des ersten Transkonduktanzverstärkers TK1 verbunden.

Wie eingangs bereits erwähnt folgt dem Zweiquadrantenmultiplizierer ZM' ein Trennverstärker TV um den Ausgang des Kompressionsverstärkers vom Zweiquadrantenmultiplizierer ZM' zu entkoppeln. Der Trennverstärker TV ist als ein "switched capacitor"-Verstärker aufgebaut und liefert eine Verstärkung von 1. Er enthält einen zweiten Transkonduktanzverstärker TK2, sowie geschaltete Kapazitäten eine sechste, siebte und achte Kapazität C6, C7, C8, die über einen vierten, fünften, sechsten Schalter erster Art und einen vierten, fünften, sechsten Schalter zweiter Art betrieben werden. Hierbei stellen die Schalter erster und zweiter Art Transmissionsgates dar, welche mit einem Zweiphasentakt angesteuert werden. Dies bedeutet, daß falls ein Schalter erster Art geöffnet ist, ein Schalter zweiter Art sich im geschlossenen Zustand befindet.

Im einzelnen ist der vierte Schalter erster Art S14 zwischen dem Ausgang des ersten Transkonduktanzverstärkers TK1 und einem ersten Anschluß der sechsten Kapazität C6 geschaltet, wobei zwischen diesem ersten Anschluß und Masse GND ein vierter Schalter zweiter Art S24 angeschlossen ist. Der zweite Anschluß der sechsten Kapazität C6 ist hierbei mit einem ersten Anschluß des dritten Transkonduktanzverstärkers TK3 und über eine Serienschaltung gebildet mit Hilfe des fünften Schalters erster Art S15 und des fünften Schalters zweiter Art S25 mit Masse GND verbunden. Bei dieser Serienschaltung ist der fünfte Schalter zweiter Art S25 einseitig an Masse GND angeschlossen.

Der Ausgang des dritten Transkonduktanzverstärkers TK3, der einen Ausgang des Trennverstärkers TV bildet und über den das Ausgangssignal am Ausgang $U_{a'}$ des Kompressionsverstärkers abgegriffen werden kann, ist über die siebte Kapazität C7 auf einen Mittenanschluß zwischen dem fünften Schalter erster Art S15 und dem fünften Schalter zweiter Art S25 rückgekoppelt. Ein sechster Schalter erster Art S16 und ein sechster Schalter zweiter Art S26, welche ebenfalls eine Serienschaltung bilden, sind zwischen Masse GND und dem Ausgang des dritten Transkonduktanzverstärkers TK3 geschaltet, wobei der sechste Schalter erster Art S16 einseitig an Masse GND angeschlossen ist. Weiterhin ist ein erster Anschluß der achten Kapazität C8 an einen Mittenabgriff zwischen dem sechsten Schalter erster Art S16 und dem sechsten Schalter zweiter Art S26 und der zweite Anschluß der achten Kapazität C8 auf den ersten Eingang des dritten Transkonduktanzverstärkers TK3 geschaltet. Schließlich ist noch der zweite Anschluß des dritten Transkonduktanzverstärkers TK3 mit Masse GND zu verbinden.

Im Rückkopplungszweig befindet sich wie bereits angegeben der Verstärker mit veränderbarer Verstärkung SC, der als "switched capacitor"-Verstärker aufgebaut ist, und der einen vierten Transkonduktanzverstärker TK4 enthält. Weiterhin vorhanden sind zuschaltbare Kapazitäten, eine neunte, zehnte, elfte und zwölfte Kapazität C9, C10, C11 und C12, eine Integratorkapazität C14 sowie weitere Schalter erster, zweiter und dritter Art. Mit Hilfe der Schalter dritter Art läßt sich das Verhältnis von Eingangs- zu Integratorkapazität und damit die Verstärkung ändern. Der Verstärkungsbereich erstreckt sich hierbei von

$$0 < \alpha < \frac{Cmax}{C_{14}} \text{ mit Cmax} = C9 + C10 + C11 + C12$$

Dies ermöglicht eine Änderung der Schwellspannung, ab welcher die Kompression einsetzt. Über die erste Kapazität C1 wird das AGC-Eingangssignal auf den Gateanschluß des dritten p-Kanal-Feldeffekttransistors P3 der Gleichrichterstufe GR′ eingekoppelt. Auch im Verstärker mit veränderbarer Verstärkung SC sind die vorhandenen Kapazitäten wieder als geschaltete Kapazitäten (switched capacitor) ausgeführt, während die Schalter dritter Art als einfache Ein/Ausschalter realisiert werden können.

Im einzelnen ist zwischen dem ersten Eingang des vierten Transkonduktanzverstärkers TK4 und dem Eingang des Verstärkers mit veränderbarer Verstärkung SC ein paralleles Kapazitätsnetzwerk und ein siebter Schalter zweiter Art S27 angeordnet, wobei der Mittenabgriff zwischen dem parallelen Kapazitätsnetzwerk und dem siebten Schalter zweiter Art S27 über einen siebten Schalter erster Art S17 mit Masse GND verbunden ist. Das parallele Kapazitätsnetzwerk nach Figur 5 enthält vier Serienschaltungen, wobei jede Serienschaltung aus einer Kapazität und einem Schalter dritter Art besteht. Hierbei ist die neunte Kapazität C9 in Serie zu dem ersten Schalter dritter Art S31, die zehnte Kapazität C10 in Serie zum zweiten Schalter dritter Art S32, die elfte Kapazität C11 in Serie geschaltet zum dritten Schalter dritter Art S33 und schließlich die zwölfte Kapazität C12 liegt in Serie zum vierten Schalter dritter Art S34. Alle vier Serienschaltungen sind jeweils an ihren beiden Anschlüssen parallel geschaltet und bilden das parallele Kapazitätsnetzwerk, welches zwischen dem ersten Eingang des vierten Transkonduktanzverstärkers TK4 und dem siebten Schalter zweiter Art S27 angeordnet ist. Der Ausgang des vierten Transkonduktanzverstärkers TK4, der gleichzeitig den Ausgang des Verstärkers veränderbarer Verstärkung SC bildet ist über eine Serienschaltung bestehend aus einer dreizehnten Kapazität C13 und einem achten Schalter zweiter Art S28 sowohl mit dem parallelen Kapazitätsnetzwerk als auch mit dem ersten Eingang des vierten Transkonduktanzverstärkers TK4 verbunden. Weiterhin ist der Mittenabgriff zwischen diesem achten Schalter zweiter Art S28 und der dreizehnten Kapazität C13 über einen achten Schalter erster Art S18 mit Masse GND verbunden. Zusätzlich ist der Ausgang des vierten Transkonduktanzverstärkers TK4 über einen neunten Schalter erster Art S19 in Serie zur vierzehnten Kapazität C14 auf den ersten Eingang des vierten Transkonduktanzverstärkers T4 rückgekoppelt und der Mittenabgriff zwischen dem neunten Schalter erster Art S19 und der vierzehnten Kapazität C14 ist über den neunten Schalter zweiter Art S29 mit Masse GND verschaltet. Schließlich ist der zweite Eingang des vierten Transkonduktanzverstärkers TK4 ebenfalls mit Masse GND verbunden.

Figur 6 zeigt die Realisierung der Referenzvorspannungsschaltung, welche nach Figur 5 gemeinsam mit dem zweiten n-Kanal-Feldeffekttransistor N2 die Referenzstromquelle RI bildet. Die Referenzvorspannungsschaltung ist grundsätzlich ähnlich der Kompressionsverstärkerschaltung nach Figur 5 aufgebaut und enthält einen weiteren Zweiquadrantenmultiplizierer mit vorgeschaltetem Spannungsteiler ZM″, und im Rückkopplungszweig einen Verstärker mit geschalteten Kapazitäten SC′ sowie ein nachfolgendes Rückkopplungsnetzwerk RK. In der Referenzvorspannungsschaltung wird wieder der gleiche Transkonduktanzverstärker TK1 im Zweiquadrantenmultiplizierer ZM″ wie beim Kompressionsverstärker eingesetzt. Am vorgeschalteten Spannungsteiler liegt eine Referenzspannung $U_{Ref}$ an, die auch mit der positiven Versorgungsspannung $V_{DD}$ identisch sein kann. Unabhängig vom Absolutwert aller eingesetzten Widerstände soll der rückgekoppelte Strom am Ausgang des Rückkopplungszweigs so groß wie der Ausgangsstrom der Referenzstromquelle sein, so daß die Verstärkung eins wird. Im Gegensatz zum vorgeschalteten Spannungsteiler des Zweiquadrantenmultiplizierers ZM′ in Figur 5 ist die Dämpfung der Referenzvorspannungsschaltung um den Faktor 2 höher, so daß am Ausgang des weiteren Zweiquadrantenmultiplizierers ZM″ eine Ausgangsspannung von $U_{REF/2}$ zu erwarten ist. Hierzu ist der Widerstandswert von R2′ halb so hoch gewählt wie der von R2 in Figur 5. Die Ausgangsspannung des weiteren Zweiquadrantenmultiplizierers ZM″ wird wieder mit der Referenzspannung $U_{REF}$ verglichen. Dies geschieht im Differenzeingang des Verstärkers mit geschalteten Kapazitäten SC′, der als "switched capacitor" Integrator aufgebaut ist. Von der Kapazität C4 gelangt die Ladung $C_0 \cdot U_{REF}$ im Falle des geschlossenen Schalters S23 auf den Integratoreingang während von der Kapazität C3, die doppelt so groß ausgelegt ist wie die Kapazität C4, wird die Ladung $-2C_0$ multipliziert mit der Ausgangsspannung des weiteren Zweiquadrantenmultiplizierers ZM″ auf den Integratoreingang geschaltet. Ist die Ausgangsspannung des Zweiquadrantenmultiplizierers ZM″ größer als die Hälfte der Referenzspannung $U_{REF/2}$, so steigt die Spannung am Integratorausgang. Hierdurch verringert sich aber der Strom durch den p-Kanal-Feldeffekttransistor P4 im Rückkopplungsnetzwerk RK. Ist die Ausgangsspannung des weiteren Zweiquadrantenmultiplizierers ZM″ je-

7

doch kleiner als die Referenzspannung $U_{REF/2}$, so kehren sich die Verhältnisse um und der Strom erhöht sich. Über eine Stromspiegelschaltung, gebildet durch den dritten und vierten n-Kanal-Feldeffekttransistor N3, N4 im Rückkopplungsnetzwerk RK wird dieser Strom als Steuerstrom dem ersten Transkonduktanzverstärker TK1 zugeführt. Nimmt der Steuerstrom ab, so verringert sich auch die Verstärkung. Es wird sich daher aufgrund der Rückkopplung ein Gleichgewicht einstellen, bei dem die Ausgangsspannung des Zweiquadrantenmultiplizierers $U_{REF/2}$ ist. Die Spannung am Ausgang der Referenzvorspannungsschaltung ist dann so, daß die Verstärkung des Kompressionsverstärkers mit ausgeschalteter Kompression gerade 1 ist. Dies kann angenommen werden, da sich der Kompressionsverstärker und die Referenzvorspannungsschaltung auf demselben Chip befinden und so die Streuung der Widerstandsbeläge und Transistorskonstanten gering ist.

Im einzelnen ist die Verschaltung der Referenzvorspannungsschaltung wie folgt vorzunehmen. Das Rückkopplungsnetzwerk enthält einen dritten und vierten n-Kanal-Feldeffekttransistor N3, N4 und einen vierten und fünften p-Kanal-Feldeffekttransistor P4, P5, wobei ein erster Anschluß des dritten n-Kanal-Feldeffekttransistors N3, ein erster Anschluß des vierten n-Kanal-Feldeffekttransistors N4 und ein Gateanschluß des fünften p-Kanal-Feldeffekttransistors P5 mit einer negativen Versorgungsspannung $V_{SS}$ verschaltet ist und ein erster Anschluß des fünften p-Kanal-Feldeffekttransistors an die positive Versorgungsspannung $V_{DD}$ angeschlossen ist. Ein zweiter Anschluß des fünften p-Kanal-Feldeffekttransistors P5 ist mit einem ersten Anschluß des vierten p-Kanal-Feldeffekttransistors P4 verschaltet und ein zweiter Anschluß des vierten p-Kanal-Feldeffekttransistors P4, ein zweiter Anschluß und ein Gateanschluß des vierten n-Kanal-Feldeffekttransistors N4 ist mit dem Gateanschluß des dritten n-Kanal-Feldeffekttransistors N3 verbunden und bilden gemeinsam den Ausgang der Referenzvorspannungsschaltung. Dieser Ausgang ist mit den Gateanschlüssen des ersten und zweiten n-Kanal-Feldeffekttransistors N1, N2 im Kompressionsverstärker Figur 5 verschaltet. Hierbei bilden die beiden n-Kanal-Feldeffekttransistoren N3 und N4 wie bereits angegeben eine Stromspiegelschaltung, wobei der zweite Eingang des dritten n-Kanal-Feldeffekttransistors N3 der Ausgang des Rückkopplungsnetzwerkes RK bildet und auf den Steuereingang des ersten Transkonduktanzverstärkers TK1 rückgekoppelt ist. Der Gateanschluß des vierten p-Kanal-Feldeffekttransistors P4 ist an den Ausgang des Verstärkers mit geschalteten Kapazitäten SC′ angeschlossen und stellt den Eingang des Rückkopplungsnetzwerkes RK dar.

Der weitere Zweiquadrantenmulitplizierer ZM″ ist ähnlich aufgebaut wie der Zweiquadrantenmultiplizierer ZM des Kompressionsverstärkers Figur 5. Er enthält den gleichen Transkonduktanzverstärker TK1 wie der Zweiquadrantenmultiplizierer ZM′ Figur 5 und einen vorgeschalteten Spannungsteiler. Hierbei ist im Gegensatz zur Figur 5 der zweite Widerstand R2′ in seinem Widerstandswert halb so hoch gewählt wie der Widerstandswert des zweiten Widerstands R2 im vorgeschalteten Spannungsteiler des Kompressionsverstärkers. Am Eingang des vorgeschalteten Spannungsteilers wird eine Referenzspannung $U_{REF}$ angelegt, die wie bereits angegeben mit der Versorgungsspannung $V_{DD}$ identisch sein kann. Durch diese Maßnahmen und durch die Rückkopplungsschaltung bestehend aus dem Verstärker mit geschalteten Kapazitäten SC′ und dem Rückkopplungsnetzwerk RK ist eine Ausgangsspannung von $U_{REF/2}$ zu erwarten. In der übrigen Verschaltung entspricht der weitere Zweiquadrantenmultiplizierer ZM″ der Verschaltung des Zweiquadrantenmultiplizierers ZM′ des Kompressionsverstärkers. Gleiche Bezugszeichen aus Figur 5 finden daher auch in Figur 6 Verwendung.

Der Ausgang des weiteren Zweiquadrantenmulitplizierers ZM″ ist nach Figur 6 mit dem Verstärker mit geschalteten Kapazitäten SC′ verbunden. Er enthält eine dritte, vierte und fünfte Kapazität C3, C4 und C5, einen ersten, zweiten und dritten Schalter erster Art S11, S12, S13 und einen ersten, zweiten und dritten Schalter zweiter Art S21, S22 und S23. Der erste Schalter erster Art S11 ist mit dem ersten Schalter zweiter Art S21 seriell zwischen dem Ausgang des weiteren Zweiquadrantenmultiplizierers ZM″ und Masse GND geschaltet, wobei der erste Schalter zweiter Art S21 einseitig mit Masse GND verbunden ist. Der zweite Schalter erster Art S12 ist mit dem zweiten Schalter zweiter Art S22 seriell zwischen Masse GND und dem ersten Eingang des zweiten Transkonduktanzverstärkers TK2 geschaltet, wobei hierbei der zweite Schalter erster Art S12 einseitig auf Masse GND gelegt ist. Der dritte Schalter erster Art S13 und der dritte Schalter zweiter Art S23 sind seriell zwischen Masse GND und der Referenzspannung $U_{REF}$ anzuschließen, wobei die Masse GND mit dem dritten Schalter erster Art S13 zu verbinden ist. Die dritte Kapazität C3, die in ihrer Größe doppelt so groß auszulegen ist wie die vierte Kapazität C4 ist einerseits an einen Mittenanschluß zwischen dem ersten Schalter erster Art S11 und dem ersten Schalter zweiter Art S21 und andererseits an dem Mittenanschluß zwischen dem zweiten Schalter erster Art S12 und dem zweiten Schalter zweiter Art S22 geschaltet, während die vierte Kapazität C4 einerseits an einen Mittenanschluß zwischen dem dritten Schalter erster Art S13 und dem dritten Schalter zweiter Art S23 und andererseits an einen Mittenanschluß zwischen dem zweiten Schalter erster Art S12 und dem zweiten Schalter zweiter Art S22 anzuschließen ist. Der Ausgang des zweiten Transkonduktanzverstärkers TK2, der auch den Ausgang des Verstärkers mit geschalteten Kapazitäten SC′ darstellt, ist über eine fünfte Kapazität C5 auf den ersten Eingang des zweiten Transkonduktanzverstärkers TK2 rückgekoppelt und der zweite Eingang des zweiten Transkonduktanzverstärkers ist ebenfalls mit Masse GND verschaltet. Schalter erster und zweiter Art können wieder als Transmissionsgates realisiert werden.

Für große Eingangspegel nähern sich die Ausgangskennlinien des Kompressionsverstärkers nach Figur 4 einem konstanten Ausgangspegel. Um zu Ausgangskennlinien des Kompressionsverstärkers zu gelangen, bei der der Zuwachs der Verstärkung auch nach Erreichen der Schwellspannung größer Null ist, sollte der Steuerstrom, er ist beim Transkonduktanzverstärker proportional zur Verstärkung, mit wachsender Amplitude weniger stark (hyperbelförmig) abnehmen wie dies in der Formel zum Verstärkungsfaktor

$$V_u\,(U_e)\ =\ (\frac{U_e}{U_{eth}})^{-\,(1\,-\,K_v)}$$

ausgedrückt ist. Annähern läßt sich dieser Verlauf der Ausgangskennlinie dadurch, daß man die Stromkennlinie des Steuertransistors im Rückkopplungszweig in umgekehrter Richtung durchläuft. Für diesen Steuertransistor wählt man den Arbeitspunkt so, daß der maximale Steuerstrom $I_p$ gleich $I_0$ fließt, welcher die Verstärkung 1 liefert. Der konstante Strom $I_0$ wird hierbei aus einer Referenzspannungsquelle entnommen, deren Ausgang auf einen p-Kanal-Feldeffekttransistor geschaltet ist.

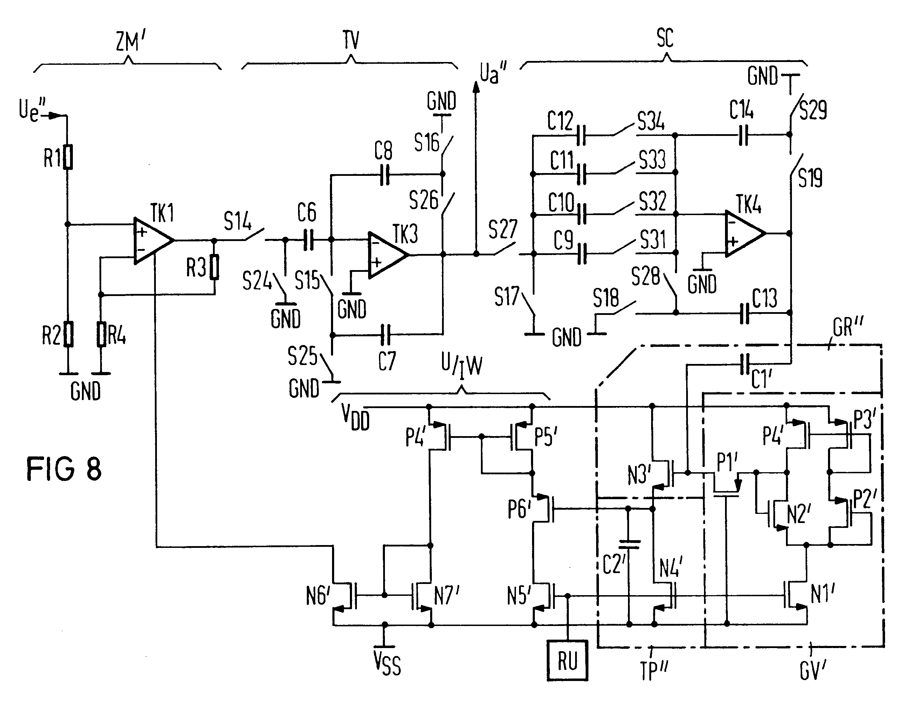

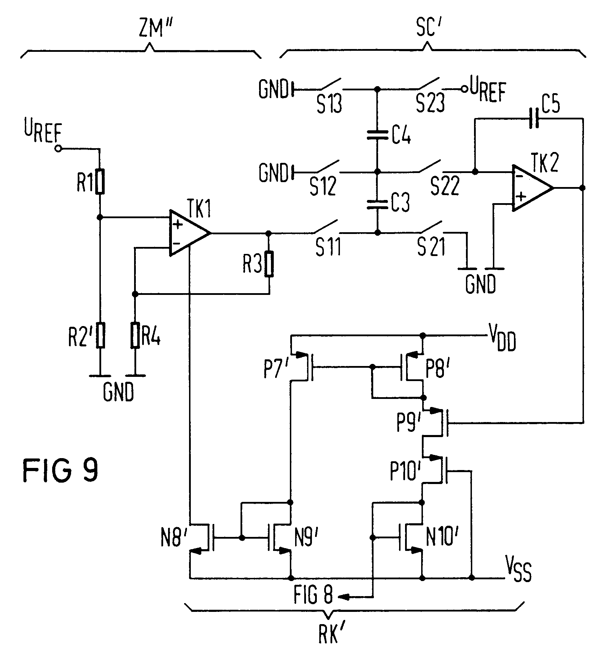

Figur 7 zeigt hierfür einen erfindungsgemäßen Kompressionsverstärker, der in CMOS-Technologie realisiert werden kann, und der eine geänderte Rückkopplungsschaltung aufweist. Der Kompressionsverstärker nach Figur 7 enthält ebenfalls einen Zweiquadrantenmultiplizierer ZM′, einen gegebenenfalls hinzuzufügenden Trennverstärker TV, sowie im Rückkopplungszweig einen Verstärker mit veränderbarer Verstärkung SC, einer Gleichrichterstufe GR″ mit einer angeschlossenen Schaltung zur Vorspannungserzeugung GV′, einen Tiefpaß TP″ und einen Spannungs-/Stromwandler U/IW, dessen Ausgang auf den Zweiquadrantenmulitplizierer ZM′ rückgekoppelt ist. Weiterhin ist an den Spannungs-/Stromwandler U/IW eine Referenzspannungsquelle RU angeschlossen. Der Zweiquadrantenmultiplizierer ZM′ ist ebenfalls wie im Blockschaltbild Figur 4 zwischen dem Ein- und Ausgang $U_{e″}$, $U_{a″}$ des Kompressionsverstärkers geschaltet, während der Verstärker mit veränderbarer Verstärkung SC zwischen der Gleichrichterstufe GR″ und dem Ausgang des Kompressionsverstärkers $U_{a″}$ geschaltet ist. Schließlich ist der Ausgang der Gleichrichterstufe GR″ über den Tiefpaß TP″ mit dem Eingang des Spannungs-/Stromwandlers U/IW verschaltet. Aus den nachfolgenden Figuren Figur 8 und Figur 9 ist zu entnehmen, daß zu der Realisierung dieses Kompressionsverstärkers einzelne Komponenten wie der Zweiquadrantenmultiplizierer ZM′, der Trennverstärker TV und der Verstärker mit veränderbarer Verstärkung SC genau gleich aufgebaut werden können wie die entsprechenden Komponenten des Kompressionsverstärkers in Figur 4.

Die Realisierung auf Transistorebene in Figur 8 zeigt den Zweiquadrantenmultiplizierer ZM′ mit angeschlossenem Trennverstärker TV, sowie die geänderte Rückkopplungsschaltung. Das verstärkte Ausgangssignal des Verstärkers mit veränderbarer Verstärkung SC wird über eine erste Kapazität C1′ kapazitiv auf den Gateanschluß des dritten n-Kanal-Feldeffekttransistors N3′ eingekoppelt. Zusammen mit dieser Kapazität bildet der dritte n-Kanal-Feldeffekttransistor N3′ einen Spitzenwertgleichrichter und die Gleichrichterstufe GR″. Das gleichgerichtete Signal wird anschließend zur Steuerung des Kaskodetransistors (gebildet durch den sechsten p-Kanal-Feldeffekttransistor P6′) auf dessen Gateanschluß gelegt. Über zwei angeschlossene Stromspiegelschaltungen, gebildet jeweils durch die beiden Feldeffekttransistoren P4′, P5′ sowie N6′, N7′ setzt der Kaskodetransistor P6′ das gleichgerichtete Signal in den Steuerstrom $I_p$ um. Durch die konstante Spannung am Ausgang der Referenzspannungsquelle RU die auf dem Gateanschluß des fünften n-Kanal-Feldeffekttransistors N5′ angelegt wird, wird ein Strom $I_0$ eingeprägt. Für den Kaskodetransistor P6′, der auch als Steuertransistor bezeichnet werden kann, wird die Stromkennlinie in umgekehrter Richtung eingesetzt. Das heißt für Gatespannungen kleiner als $V_{DD}$ - 2$T_P$ ($V_{TP}$ = Einsatzspannung des p-Kanal-Feldeffekttransistors) steigt der Strom durch den Steuertransistor quadratisch an zu einem Maximalwert von $I_0$. Den Arbeitspunkt des Kaskode- bzw. Steuertransistors P6′ legt man nun so, daß der maximale Strom $I_0$ fließen kann. Wird über den dritten n-Kanal-Feldeffekttransistor N3′ ein Wechselsignal gleichgerichtet, steigt die Spannung am Gateanschluß des Kaskode- bzw. Steuertransistors P6′ an. Hierdurch verringert sich der Steuerstrom $I_P$ und die Verstärkung ebenfalls. Falls der Kaskode- bzw. der Steuertransistor P6′ und der fünfte p-Kanal-Feldeffekttransistor P5′ gleich aufgebaut werden benötigen sie beide die gleiche Gate-Source-Spannung für den Strom $I_0$. Da die Ströme sehr klein sind kann man auch sagen, daß die Gatespannung um zwei Einsatzspannungen unterhalb der positiven Versorgungsspannung $V_{DD}$ liegen soll. Der Arbeitspunkt des Kaskode- bzw. Steuertransistors P6′ muß aber über dem des dritten n-Kanal-Feldeffekttransistors N3′ (Gleichrichtertransistor) eingestellt werden. Also muß die Gatespannung am dritten n-Kanal-Feldeffekttransistor N3′ um eine Einsatzspannung höher liegen als die des Kaskode- bzw. Steuertransistors P6′. Zur Erzeugung dieser Spannung wird eine Schaltung zur Vorspannungserzeugung GV′ eingesetzt, die im folgenden näher beschrieben ist.

Die Schaltung zur Vorspannungserzeugung GV′ enthält einen ersten, zweiten, dritten und vierten p-Kanal-Feldeffekttransistor P1′, P2′, P3′ und P4′ sowie einen ersten und zweiten n-Kanal-Feldeffekttransistor N1′, N2′. Ein Gateanschluß des ersten p-Kanal-Feldeffekttransistors P1′ und ein erster Anschluß des ersten n-Kanal-Feldeffekttransistors N1′ sind gemeinsam auf eine negative Versorgungsspannung $V_{SS}$ gelegt, während ein erster Anschluß des ersten p-Kanal-Feldeffekttransistors P1' und einer erster Anschluß des zweiten n-Kanal-Feldeffekttransistors N2' gemeinsam auf einen Gateanschluß des zweiten n-Kanal-Feldeffekttransistors N2' geschaltet. Der zweite Anschluß des zweiten n-Kanal-Feldeffekttransistors N2' und der zweite Anschluß des ersten n-Kanal-Feldeffekttransistors N1' sind gemeinsam auf den ersten Eingang des zweiten p-Kanal-Feldeffekttransistors P2' und den Gateanschluß des zweiten p-Kanal-Feldeffekttransistors P2' gelegt. Weiterhin ist ein zweiter Anschluß des zweiten p-Kanal-Feldeffekttransistors P2' mit dem ersten Eingang des dritten p-Kanal-Feldeffekttransistors P3' und dem Gateanschluß des dritten und vierten p-Kanal-Feldeffekttransistors P3', P4' verschaltet und ein erster Anschluß des zweiten n-Kanal-Feldeffekttransistors N2' ist mit dem ersten Anschluß des vierten p-Kanal-Feldeffekttransistors P4' verbunden. Ein zweiter Anschluß des dritten p-Kanal-Feldeffekttransistors P3' und ein zweiter Anschluß des vierten p-Kanal-Feldeffekttransistors P4' sind gemeinsam auf die positive Versorgungsspannung $V_{DD}$ gelegt und ein zweiter Anschluß des ersten p-Kanal-Feldeffekttransistors P1' ist mit der Gleichrichterstufe GR' über den Gateanschluß des dritten n-Kanal-Feldeffekttransistors N3' verbunden. Hierbei ist der zweite und dritte p-Kanal-Feldeffekttransistor P2' und P3' als Diode verschaltet, so daß ihre GateSource-Spannung identisch der mit dem Steuer- bzw. Kaskodetransistor P6' und dem fünften n-Kanal-Feldeffekttransistor N5' ist. Durch die Stromspiegelschaltung, gebildet durch den dritten und vierten p-Kanal-Feldeffekttransistor P3' und P4' wird auch im Stromzweig zwischen dem vierten p-Kanal-Feldeffekttransistor P4' und dem zweiten n-Kanal-Feldeffekttransistor N2' der gleiche Strom wie durch den Stromzweig des zweiten und dritten p-Kanal-Feldeffekttransistors P2' und P3' fließen. Am Summationspunkt zwischen dem zweiten n-Kanal-Feldeffekttransistor N2' und dem zweiten p-Kanal-Feldeffekttransistor P2' stellt sich dann eine Spannung ein, die $V_{DD}$ - $2V_{TP}$ ($V_{TP}$ = Einsatzspannung des p-Kanal-Feldeffekttransistors). Auch der zweite n-Kanal-Feldeffekttransistor N2' arbeitet als Diode und erzeugt eine Gate-Source-Spannung von $V_{TN}$, wobei $V_{TN}$ die Einsatzspannung eines n-Kanal-Feldeffekttransistors beschreibt. Am Gateanschluß des zweiten n-Kanal-Feldeffekttransistors N2' stellt sich dann eine Spannung von $U_{GN2'}$ = $V_{DD}$ -$2 V_{TP}$ + $V_{TN}$ ein. Diese gesuchte Vorspannung wird über den als Widerstand wirkenden ersten p-Kanal-Feldeffekttransistor P1' an den Gateanschluß des dritten n-Kanal-Feldeffekttransistors N3' weitergeleitet. Erhöht man die Stromdichten in der Schaltung zur Vorspannungserzeugung zum Einsellen des Arbeitspunktes im Vergleich zu dem Stromzweig, gebildet aus den Feldeffekttransistoren N5', P6' und P5', so erhält man einen Arbeitspunkt bei dem sichergestellt ist, daß der Kaskode- bzw. Steuertransistor P6' den Strom $I_0$ sicher durchläßt.

Die Gleichrichterstufe GR" enthält wie bereits angegeben einen dritten n-Kanal-Feldeffekttransistor N3' und eine erste Kapazität C1', wobei die erste Kapazität C1' zwischen dem Ausgang des Verstärkers mit veränderbarer Verstärkung SC und dem Gateanschluß des dritten n-Kanal-Feldeffekttransistors N3' und dem zweiten Anschluß des ersten p-Kanal-Feldeffekttransistors P1' aus der Schaltung zur Vorspannungserzeugung GV' geschaltet ist. Ein erster Anschluß des dritten n-Kanal-Feldeffekttransistors N3' ist mit der positiven Versorgungsspannung $V_{DD}$ und ein zweiter Anschluß des dritten n-Kanal-Feldeffekttransistors N3' mit dem Tiefpaß TP" verschaltet.

Der Tiefpaß TP" enthält eine zweite Kapazität C2' und einen vierten n-Kanal-Feldeffekttransistors N4', wobei der erste Anschluß der zweiten Kapazität C2' und ein erster Anschluß des vierten n-Kanal-Feldeffekttransistors N4' gemeinsam mit dem Ausgang der Gleichrichterstufe, in diesem Falle dem zweiten Anschluß des dritten n-Kanal-Feldeffekttransistors N3' verschaltet ist. Der zweite Anschluß der zweiten Kapazität N2' und der zweite Anschluß des vierten n-Kanal-Feldeffekttransistors N4' sind gemeinsam mit der negativen Versorgungsspannung $V_{SS}$ verbunden und der erste Anschluß der zweiten Kapazität C2' und der erste Anschluß des ersten n-Kanal-Feldeffekttransistors N4' bilden gemeinsam den Ausgang des Tiefpasses TP".

Der am Ausgang des Tiefpasses TP" angeschlossene Spannungs-/Stromwandler U/IW enthält einen vierten, fünften und sechsten n-Kanal-Feldeffekttransistor N5', N6', N7' und einen vierten, fünften und sechsten p-Kanal-Feldeffekttransistor P4', P5' und P6'. Die beiden p-Kanal-Feldeffekttransistoren P4' und P5' bilden eine erste Stromspiegelschaltung und die beiden n-Kanal-Feldeffekttransistoren N6' und N7' bilden die zweite Stromspiegelschaltung. Im einzelnen ist der erste Anschluß des fünften n-Kanal-Feldeffekttransistors N5' und der erste Anschluß des sechsten n-Kanal-Feldeffekttransistors N6' sowie der erste Anschluß des siebten n-Kanal-Feldeffekttransistors N7' gemeinsam an der negativen Versorgungsspannung $V_{SS}$ angeschlossen und ein erster Anschluß des vierten p-Kanal-Feldeffekttransistors P4' und ein erster Anschluß des fünften p-Kanal-Feldeffekttransistors P5' mit der positiven Versorgungsspannung $V_{DD}$ verbunden. Der Gateanschluß des sechsten n-Kanal-Feldeffekttransistors N6' und der Gateanschluß des siebten n-Kanal-Feldeffekttransistors N7' sind gemeinsam auf den zweiten Anschluß des siebten n-Kanal-Feldeffekttransistors N7' und den zweiten Anschluß des vierten p-Kanal-Feldeffekttransistors P4' verschaltet und ein Gateanschluß des vierten p-Kanal-Feldeffekttransistors P4' und ein Gateanschluß des fünften p-Kanal-Feldeffekttransistors P5' sind gemeinsam auf einen zweiten Eingang des fünften p-Kanal-Feldeffekttranssistors P5' und den ersten Eingang des sechsten p-Kanal-Feldeffekttransistors P6', der auch als Steuer- bzw. Kaskodetransistor bezeichnet wird, aufgeschaltet. Weiterhin ist ein zweiter Anschluß des sechsten p-Kanal-Feldeffekttransistors P6′ mit dem zweiten Anschluß des fünften n-Kanal-Feldeffekttransistors N5′ verbunden und ein Gateanschluß des sechsten p-Kanal-Feldeffekttransistors P6′ ist mit dem Ausgang des Tiefpasses zu verbinden. Der zweite Anschluß des sechsten n-Kanal-Feldeffekttransistors N6′ bildet den Ausgang des Spannungs-/Stromwandlers und ist auf den Zweiquadrantenmultiplizierer ZM′ rückgekoppelt.

Der Aufbau der übrigen Komponenten, wie des Zweiquadrantenmultiplizierers ZM′, des Trennverstärkers TV und des Verstärkers mit veränderbarer Verstärkung SC kann wie die entsprechenden Komponenten nach den Beschreibungsangaben in Figur 5 aufgebaut werden. Daher werden in der Realisierung der einzelnen Komponenten nach Figur 8 die gleichen Bezugszeichen verwendet wie bei den entsprechenden Komponenten nach Figur 5.

Figur 9 schließlich zeigt die Realisierung der Referenzspannungsquelle RVU auf Transistorebene. Diese Schaltung ist in weiten Teilen wie die Referenzvorspannungsschaltung nach Figur 6 aufgebaut, und enthält einen Zweiquadrantenmultiplizierer ZM″ und im Rückkopplungszweig einen Verstärker mit geschalteten Kapazitäten SC′ sowie ein Rückkopplungsnetzwerk RK′. Die Realisierung des Zweiquadrantenmultiplizierers ZM″ sowie des als "switched capacitor"-Verstärker realisierten Verstärker SC′ ist wie in den entsprechenden Komponenten nach Figur 6 vorzunehmen, so daß gleiche Bezugszeichen hier auch Verwendung finden. Auch das Rückkopplungsnetzwerk RK′ ist auf einen Steuereingang des Zweiquadrantenmultiplizierers ZM″ rückgekoppelt. Im Unterschied zur Schaltung nach Figur 6 enthält die Referenzspannungsquelle in Figur 9 ein geändertes Rückkopplungsnetzwerk. Es enthält einen achten, neunten und zehnten n-Kanal-Feldeffekttransistor N8′, N9′ und N10′ sowie einen siebten, achten, neunten und zehnten p-Kanal-Feldeffekttransistor P7′, P8′, P9′ und P10′ wobei die beiden p-Kanal-Feldeffekttransistoren P7′, P8′ sowie die beiden n-Kanal-Feldeffekttransistoren N8′ und N9′ je eine Stromspiegelschaltung bilden. Der erste Anschluß des achten n-Kanal-Feldeffekttransistors N8′, der erste Anschluß des neunten n-Kanal-Feldeffekttransistors N9′, ein erster Anschluß des zehnten n-Kanal-Feldeffekttransistors N10′ und ein Gateanschluß des zehnten p-Kanal-Feldeffekttransistors P10′ sind gemeinsam mit einer negativen Versorgungsspannung $V_{SS}$ verschaltet und ein Gateanschluß des achten n-Kanal-Feldeffekttransistors N8′ und ein Gateanschluß des neunten n-Kanal-Feldeffekttransistors N9′ sind gemeinsam mit einem zweiten Anschluß des neunten n-Kanal-Feldeffekttransistors N9′ und mit einem ersten Anschluß des siebten p-Kanal-Feldeffekttransistors P7′ verbunden. Der zweite Anschluß des siebten n-Kanal-Feldeffekttransistors P7′ ist mit einem ersten Anschluß des achten p-Kanal-Feldeffekttransistors P8′ auf die positive Versorgungsspannung $V_{DD}$ gelegt. Der Gateanschluß des siebten p-Kanal-Feldeffekttransistors P7′ und ein Gateanschluß des achten p-Kanal-Feldeffekttransistors P8′ sind gemeinsam auf den zweiten Anschluß des achten p-Kanal-Feldeffekttransistors P8′ und auf einen ersten Anschluß des neunten p-Kanal-Feldeffekttransistors P9′ aufgeschaltet. Weiter ist der zweite Anschluß des neunten p-Kanal-Feldeffekttransistors P9′ mit einem ersten Anschluß des zehnten p-Kanal-Feldeffekttransistors P10′ zu verbinden und ein zweiter Anschluß des zehnten p-Kanal-Feldeffekttransistors P10′ und ein zweiter Anschluß des zehnten p-Kanal-Feldeffekttransistors N10′ sind gemeinsam auf einen Gateanschluß des zehnten n-Kanal-Feldeffekttransistors N10′ aufzuschalten. Der zweite Anschluß des achten n-Kanal-Feldeffekttransistors N8′ bildet den Ausgang des Rückkopplungsnetzwerkes RK′ und der Gateanschluß des neunten p-Kanal-Feldeffekttransistors P9′ ist an dem Ausgang des Verstärkers mit geschalteten Kapazitäten SC′ angeschlossen. Der Gateanschluß und der zweite Anschluß des zehnten n-Kanal-Feldeffekttransistors N10′ bilden den Ausgang der Referenzspannungsquelle RVU und ist auf den Gateanschluß des ersten, vierten und fünften n-Kanal-Feldeffekttransistors N1′, N4′, und N5′ aufzuschalten.


**Patentansprüche**


1. Kompressionsverstärker mit einem Zweiquadrantenmultiplizierer (ZM′, ZM″) und einem Rückkopplungszweig, der eine Gleichrichterstufe (GR′, GR″) und einen nachfolgenden Tiefpaß (TP′, TP″) enthält,
bei dem ein Ausgang des Tiefpasses (TP′, TP″) auf den Zweiquadrantenmultiplizierer (ZUM′, ZM″) rückgekoppelt ist und der Zweiquadrantenmultiplizierer (ZM′, ZM″) mit einem vorgeschalteten Spannungsteiler zwischen einem Eingang und einem Ausgang ($U_e′$, $U_a′$, $U_e″$, $U_a″$) des Kompressionsverstärkers geschaltet ist,
bei dem im Rückkopplungszweig ein Verstärker mit veränderbarer Verstärkung (SC) zwischen der Gleichrichterstufe (GR′, GR″) und dem Ausgang ($U_a′$, $U_a″$) des Kompressionsverstärkers geschaltet ist und bei dem der Gleichrichterstufe (GR′, GR″) eine Schaltung zur Vorspannungserzeugung (GV, GV′) zugeordnet ist,
**dadurch gekennzeichnet,**
daß die im Kompressionverstärker enthaltenen Transistoren in Form von Feldeffekttransistoren (P1, P1' ... P10, P10', N1, N1' ... N10, N10') ausgeführt sind,

daß der Verstärker mit veränderbarer Verstärkung (SC) ein "switched capacitor"-Verstärker ist, der einen siebten, achten und neunten Schalter erster Art (S17, S18, S19), einen siebten, achten und neunten Schalter zweiter Art (S27, S28, S29) und einen ersten, zweiten, dritten und vierten Schalter dritter Art (S31, S32, S33, S34), eine neunte, zehnte, elfte, zwölfte, dreizehnte und vierzehnte Kapazität (C9, C10, C11, C12, C13, C14) und einen vierten Transkonduktanzverstärker (TK4) enthält, wobei die Schalter erster Art zu den Schaltern zweiter Art im Gegentakt gesteuert werden, und die Schalter dritter Art von den Schaltern erster und zweiter Art unabhängig sind,

daß zwischen einem ersten Eingang des vierten Transkonduktanzverstärkers (TK4) und dem Eingang des Verstärkers der veränderbaren Verstärkung (SC) ein paralleles Kapazitätsnetzwerk und der siebte Schalter zweiter Art (S27) seriell angeordnet ist,

daß zwischen Mittenabgriff zwischen dem parallelen Kapazitätsnetzwerk und dem siebten Schalter zweiter Art (S27) einerseits und Masse (GND) andererseits der siebte Schalter erster Art (S17) angeordnet ist,

daß das parallele Kapazitätsnetzwerk die neunte Kapazität (C9) in Serie geschaltet zum ersten Schalter dritter Art (S31), parallel zur zehnten Kapazität (C10) in Serie geschaltet zum zweiten Schalter dritter Art (S32), parallel zur elften Kapazität (C11) in Serie geschaltet zum dritten Schalter dritter Art (S33), parallel zur zwölften Kapazität (C12) in Serie geschaltet zum vierten Schalter vierter Art (S34) enthält,

daß ein Ausgang des vierten Transkonduktanzverstärkers (TK4), der gleichzeitig den Ausgang des Verstärkers mit veränderbarer Verstärkung (SC) bildet über eine dreizehnte Kapazität (C13) in Serie zum achten Schalter zweiter Art (S28) sowie über den neunten Schalter erster Art (S19) in Serie zur vierzehnten Kapazität (C14) auf den ersten Eingang des vierten Transkonduktanzverstärkers (TK4) rückgekoppelt ist,

daß ein zweiter Eingang des vierten Transkonduktanzverstärkers (TK4) mit Masse (GND) verbunden ist, daß ein achter Schalter erster Art (S18) zwischen Masse (GND) und einem Mittenabgriff zwischen dem achten Schalter zweiter Art (S28) und der dreizehnten Kapazität (C13) geschaltet ist und

daß ein neunter Schalter zweiter Art (S29) zwischen Masse (GND) und einem Mittenabgriff zwischen neunten Schalter erster Art (S19) und der vierzehnten Kapazität (C14) angeordnet ist.

2. Kompressionsverstärker nach Anspruch 1,

**dadurch gekennzeichnet,**

daß zwischen dem Tiefpaß (TP') und der Gleichrichterstufe (GR') an einem Summationspunkt (S) eine Referenzstromquelle (RI) zugeschaltet ist.

3. Kompressionsverstärker nach Anspruch 2, **dadurch gekennzeichnet,** daß die Schaltung zur Vorspannungserzeugung (GV) einen ersten Feldeffekttransistor ersten Typs (N1) und einen ersten und zweiten Feldeffekttransistor zweiten Typs (P1, P2) enthält und ein Gateanschluß des ersten Feldkanalfeldeffekttransistors zweiten Typs (P1) und ein erster Anschluß des ersten Feldeffekttransistors (N1) ersten Typs gemeinsam auf einen ersten Bezugspunkt (V$_{SS}$) geschaltet ist, ein zweiter Anschluß des ersten Feldeffekttransistors (N1) ersten Typs und ein erster Anschluß des zweiten Feldeffekttransistors zweiten Typs (P2) gemeinsam mit einem Gateanschluß des zweiten Feldeffekttransistors zweiten Typs (P2) und einem ersten Eingang des ersten Feldeffekttransistors zweiten Typs (P1) geschaltet ist, daß ein zweiter Anschluß des zweiten Feldeffekttransistors zweiten Typs (P2) mit einem zweiten Bezugspunkt (V$_{DD}$) und ein zweiter Anschluß des ersten Feldeffekttransistors zweiten Typs (P1) mit der Gleichrichterstufe (GR') verbunden ist, daß die Referenzstromquelle (RI) einen zweiten Feldeffekttransistor ersten Typs (N2) und einer Referenzvorspannungsschaltung (RVU) enthält, daß ein erster Eingang des zweiten Feldeffekttransistors ersten Typs (N2) mit dem ersten Bezugspunkt (V$_{SS}$) und ein zweiter Eingang des zweiten Feldeffekttransistors ersten Typs (N2) mit dem Summationspunkt (S) verbunden ist, daß ein Gateanschluß des ersten Feldeffekttransistors ersten Typs (N1) und ein Gateanschluß des zweiten Feldeffekttransistors ersten Typs (N2) mit der Referenzvorspannungsschaltung (RVU) verschaltet ist.

4. Kompressionsverstärker nach Anspruch 3, **dadurch gekennzeichnet,** daß die Gleichrichterstufe (GR') einen dritten Feldeffekttransistor zweiten Typs (P3) und eine erste Kapazität (C1) enthält, daß die erste Kapazität (C1) zwischen einem Ausgang des Verstärkers mit veränderbarer Verstärkung (SC) und einem Gateanschluß des dritten Feldeffekttransistors zweiten Typs (P3) gemeinsam mit dem zweiten Anschluß des ersten Feldeffekttransistors zweiten Typs (P1) aus der Schaltung zur Vorspannungserzeugung (GV) geschaltet ist, daß ein erster Anschluß des dritten Feldeffekttransistors zweiten Typs (P3) mit dem zweiten Bezugspunkt (V$_{DD}$) und ein zweiter Anschluß des dritten Feldeffekttransistors zweiten Typs (P3) mit dem Summationspunkt (S) verbunden ist.

5. Kompressionsverstärker nach Anspruch 3 oder 4, **dadurch gekennzeichnet,** daß die Referenzvorspannungsschaltung (RVU) einen weiteren Zweiquadrantenmultiplizierer (ZM″) mit vorgeschaltetem Spannungsteiler und ein am Ausgang des weiteren Zweiquadrantenmultiplizierers (ZM″) angeschlossenen Rückkopplungszweig enthält, daß im Rückkopplungszweig ein weiterer Verstärker (SC′) und ein nachfolgendes Rückkopplungsnetzwerk (RK) eingebaut ist, daß ein Ausgang des Rückkopplungsnetzwerks (RK) auf den weiteren Zweiquadrantenmulitplizierer (ZM″) rückgekoppelt ist, daß das Rückkopplungsnetzwerk (RK) einen dritten und vierten Feldeffekttransistor ersten Typs (N3, N4) und einen vierten und fünften Feldeffekttransistor zweiten Typs (P4, P5) enthält, daß ein erster Anschluß des dritten Feldeffekttransistors ersten Typs (N3), ein erster Anschluß des vierten Feldeffekttransistors ersten Typs (N4) und ein Gateanschluß des fünften Feldeffekttransistors zweiten Typs (P5) mit dem ersten Bezugspunkt (V$_{SS}$) verschaltet ist, daß ein erster Anschluß des fünften Feldeffekttransistors zweiten Typs (P5) mit dem zweiten Bezugspunkt (V$_{DD}$) und ein zweiter Anschluß des fünften Feldeffekttransistors zweiten Typs (P5) mit einem ersten Anschluß des vierten Feldeffekttransistors zweiten Typs (P4) verbunden ist, daß ein zweiter Anschluß des vierten Feldeffekttransistors zweiten Typs (P4), ein zweiter Anschluß und ein Gateanschluß jeweils des vierten Feldeffekttransistors ersten Typs (N4) mit einem Gateanschluß des dritten Feldeffekttransistors ersten Typs (N3) und mit den Gateanschlüssen des ersten und zweiten Feldeffekttransistors ersten Typs (N1, N2) verschaltet ist, daß ein zweiter Anschluß des dritten Feldeffekttransistors ersten Typs (N3) den Ausgang des Rückkopplungsnetzwerks (RK) bildet und ein Gateanschluß des vierten Feldeffekttransistors zweiten Typs (P4) an einen Ausgang des weiteren Verstärkers mit veränderbarer Verstärkung (SC′) angeschlossen ist.

6. Kompressionsverstärker nach einem der Ansprüche 2 bis 5, **dadurch gekennzeichnet,** daß der Tiefpaß (TP′) eine zweite Kapazität (C2) einen fünften und sechsten Feldeffekttransistor ersten Typs (N5, N6) und einen sechsten und siebten Feldeffekttransistor zweiten Typs (P6, P7) enthält, daß ein erster Eingang des sechsten Feldeffekttransistors zweiten Typs (P6) und ein erster Eingang des siebten Feldeffekttransistors zweiten Typs (P7) an den zweiten Bezugspunkt (V$_{DD}$) angeschlossen ist, daß ein erster Anschluß des fünften Feldeffekttransistors ersten Typs (N5) und ein erster Anschluß des sechsten Feldeffekttransistors ersten Typs (N6) mit einem ersten Bezugspunkt (V$_{SS}$) verschaltet ist, und ein Gateanschluß des fünften Feldeffekttransistors ersten Typs (N5), ein Gateanschluß des sechsten Feldeffekttransistors ersten Typs (N6) gemeinsam mit einem zweiten Eingang des sechsten Feldeffekttransistors zweiten Typs (P6) und einem zweiten Anschluß des sechsten Feldeffekttransistors ersten Typs (N6) verschaltet ist, daß ein zweiter Anschluß des fünften Feldeffekttransistors ersten Typs (N5) den Ausgang des Tiefpasses (TP′) bildet und die zweite Kapazität (C2) zwischen dem ersten Bezugspunkt (V$_{SS}$) und einem zweiten Anschluß des siebten Feldeffekttransistors zweiten Typs (P7) verbunden ist, daß der zweite Anschluß des siebten Feldeffekttransistors zweiten Typs (P7) mit dem Summationspunkt (S) und mit einem Gateanschluß des sechsten und einem Gateanschluß des siebten Feldeffekttransistors zweiten Typs (P6, P7) verschaltet ist.

7. Kompressionsverstärker nach Anspruch 1,
   **dadurch gekennzeichnet,**
   daß der Tiefpaß (TP″) über einen Spannungs-/Stromwandler (U/IW) auf den Zweiquadrantenmultiplizierer (ZUM′) rückgekoppelt ist, daß dem Spannungs-/Stromwandler (U/IW) eine Referenzspannungsquelle (RU) zugeordnet ist, die eine von den Versorgungsspannungen (V$_{DD}$, V$_{SS}$) verschiedene Referenzspannung aufweist.

8. Kompressionsverstärker nach Anspruch 7, **dadurch gekennzeichnet,** daß die Schaltung zur Vorspannungserzeugung (GV′) einen ersten, zweiten, dritten und vierten Feldeffekttransistor zweiten Typs (P1′, P2′, P3′, P4′) und einen ersten und zweiten Feldeffekttransistor ersten Typs (N1′, N2′) enthält, daß ein Gateanschluß des ersten Feldeffekttransistors zweiten Typs (P1′) und ein erster Anschluß des ersten Feldeffekttransistors ersten Typs (N1′) gemeinsam auf einen ersten Bezugspunkt (V$_{SS}$) geschaltet sind, daß ein erster Anschluß des ersten Feldeffekttransistors zweiten Typs (P1′) und ein erster Anschluß des zweiten Feldeffekttransistors ersten Typs (N2′) gemeinsam auf einen Gateanschluß des zweiten Feldeffekttransistors ersten Typs (N2′) geschaltet ist, daß ein zweiter Anschluß des zweiten Feldeffekttransistors ersten Typs (N2′) und ein zweiter Anschluß des ersten Feldeffekttransistors ersten Typs (N1′) gemeinsam auf einen ersten Eingang des zweiten Feldeffekttransistors zweiten Typs (P2′) und auf einen Gateanschluß des zweiten Feldeffekttransistors zweiten Typs (P2′) geschaltet ist, daß ein zweiter Eingang des zweiten Feldeffekttransistors zweiten Typs mit einem ersten Eingang des dritten Feldeffekttransistors zweiten Typs (P3′) und einem Gateanschluß des dritten und vierten Feldeffekttransistors zweiten Typs (P3′, P4′) verschaltet ist, daß ein erster Anschluß des zweiten Feldeffekttransistors ersten Typs (N2′) mit einem ersten Anschluß des vierten Feldeffekttransistors zweiten Typs (P4′) verbunden ist und ein zweiter Anschluß des dritten Feldeffekttransistors zweiten Typs (P3′) und ein zweiter Anschluß des vierten Feldeffekttransistors zweiten Typs (P4′) mit dem zweiten Bezugspunkt (V_{DD}) verschaltet ist, und daß ein zweiter Anschluß des ersten Feldeffekttransistors zweiten Typs (P1′) mit der Gleichrichterstufe (GR′) verbunden ist.

9. Kompressionsverstärker nach Anspruch 8, **dadurch gekennzeichnet,** daß die Gleichrichterstufe (GR″) einen dritten Feldeffekttransistor ersten Typs (N3′) und eine erste Kapazität (C1′) enthält, daß die erste Kapazität (C1′) zwischen einem Ausgang des Verstärkers mit veränderbarer Verstärkung (SC) und einem Gateanschluß des dritten Feldeffekttransistors ersten Typs (N3′) und einem zweiten Anschluß des ersten Feldeffekttransistors zweiten Typs (P1′) aus der Schaltung zur Vorspannungserzeugung (GV′) geschaltet ist, daß ein erster Anschluß des dritten Feldeffekttransistors ersten Typs (N3′) mit dem zweiten Bezugspunkt (V_{DD}) und ein zweiter Anschluß des dritten Feldeffekttransistors esten Typs (N3′) mit dem Tiefpaß (TP″) verschaltet ist.

10. Kompressionsverstärker nach einem der Ansprüche 7, 8 oder 9, **dadurch gekennzeichnet,** daß der Tiefpaß (TP″) eine zweite Kapazität (C2′) und einen vierten Feldeffekttransistor ersten Typs (N4′) enthält, daß ein erster Anschluß der zweiten Kapazität (C2′) und ein erster Anschluß des vierten Feldeffekttransistors ersten Typs (N4′) gemeinsam mit der Gleichrichterstufe (GR″) und ein zweiter Anschluß der zweiten Kapazität (C2′) und ein zweiter Anschluß des vierten Feldeffekttransistors ersten Typs (N4′) gemeinsam mit dem ersten Bezugspunkt (V_{SS}) verschaltet ist, und der erste Anschluß der zweiten Kapazität (C2′) und der erste Anschluß des vierten Feldeffekttransistors ersten Typs (N4′) gemeinsam einen Ausgang des Tiefpasses (TP″) bilden.

11. Kompressionsverstärker nach einem der Ansprüche 7 bis 10, **dadurch gekennzeichnet,** daß der Spannungs-/Stromwandler (U/IW) einen fünften, sechsten und siebten Feldeffekttransistor ersten Typs (N5′, N6′, N7′) und einen vierten, fünften und sechsten Feldeffekttransistor zweiten Typs (P4′, P5′, P6′) enthält, daß ein erster Anschluß des fünften Feldeffekttransistors ersten Typs (N5′), ein erster Anschluß des sechsten Feldeffekttransistors esten Typs (N6′) und ein erster Anschluß des siebten Feldeffekttransistors ersten Typs (N7′) gemeinsam mit dem ersten Bezugspunkt (V_{SS}) verbunden ist, daß ein erster Anschluß des vierten Feldeffekttransistors zweiten Typs (P4′) und ein erster Anschluß des fünften Feldeffekttransistors zweiten Typs (P5′) mit dem zweiten Bezugspunkt (V_{DD}) verschaltet ist, daß ein Gateanschluß des sechsten Feldeffekttransistors ersten Typs (N6′) und ein Gateanschluß des siebten Feldeffekttransistors ersten Typs (N7′) gemeinsam mit einem zweiten Anschluß des siebten Feldeffekttransistors ersten Typs (N7′) und einem zweiten Anschluß des vierten Feldeffekttransistors zweiten Typs (P4′) verbunden ist, daß ein Gateanschluß des vierten Feldeffekttransistors zweiten Typs (P4′) und ein Gateanschluß des fünften Feldeffekttransistors zweiten Typs (P5′) gemeinsam auf einen zweiten Eingang des fünften Feldeffekttransistors zweiten Typs (P5′) und auf einen ersten Eingang des sechsten Feldeffekttransistors zweiten Typs (P6′) aufgeschaltet ist, daß ein zweiter Anschluß des sechsten Feldeffekttransistors zweiten Typs (P6′) mit einem zweiten Anschluß des fünften Feldeffekttransistors ersten Typs (N5′) verbunden ist, daß ein Gateanschluß des sechsten Feldeffekttransistors zweiten Typs (P6′) mit dem Tiefpaß (TP′) verschaltet ist und ein zweiter Anschluß des sechsten Feldeffekttransistors ersten Typs (N6′) auf den Zweiquadrantenmultiplizierer (ZM′) rückgekoppelt ist.

12. Kompressionsverstärker nach Anspruch 11, **dadurch gekennzeichnet,** daß die Referenzspannungsquelle (RU) einen weiteren Zweiquadrantenmultiplizierer (ZM″) mit vorgeschaltetem Spannungsteiler und einem am Ausgang des weiteren Zweiquadrantenmultiplizierers (ZM″) angeschlossenen Rückkopplungszweig enthält, daß im Rückkopplungszweig ein weiterer Verstärker (SC′) und ein nachfolgendes Rückkopplungsnetzwerk (RK′) eingebaut ist, daß ein Ausgang des Rückkopplungsnetzwerkes (RK′) auf den weiteren Zweiquadrantenmultiplizierer (ZM″) rückgekoppelt ist, daß das Rückkopplungsnetzwerk (RK′) einen achten, neunten und zehnten Feldeffekttransistor ersten Typs (N8′, N9′, N10′) und einen siebten, achten, neunten und zehnten Feldeffekttransistor zweiten Typs (P7′, P8′, P9′, P10′) enthält, daß ein erster Anschluß des achten Feldeffekttransistors ersten Typs (N8′), ein erster Anschluß des neunten Feldeffekttransistorsersten Typs (N9′), ein erster Anschluß des zehnten Feldeffekttransistors ersten Typs (N10′) und ein Gateanschluß des zehnten Feldeffekttransistors zweiten Typs (P10′) gemeinsam mit dem ersten Bezugspunkt (V_{SS}) verschaltet sind, daß ein Gateanschluß des achten Feldeffekttransistors ersten Typs (N8′) und ein Gateanschluß des neunten Feldeffekttransistors ersten Typs (N9′) gemeinsam mit ei-

14

nem zweiten Anschluß des neunten Feldeffekttransistors ersten Typs (N9') und mit einem ersten Anschluß des siebten Feldeffekttransistors zweiten Typs (P7') verbunden ist, daß ein zweiter Anschluß des siebten Feldeffekttransistors zweiten Typs (P7') mit einem ersten Anschluß des achten Feldeffekttransistors zweiten Typs (P8') und gemeinsam mit dem zweiten Bezugspunkt ($V_{DD}$) verschaltet ist, daß ein Gateanschluß des siebten Feldeffekttransistors zweiten Typs (P7') und ein Gateanschluß des achten Feldeffekttransistors zweiten Typs (P8') gemeinsam auf einen zweiten Anschluß des achten Feldeffekttransistors zweiten Typs (P8') und auf einen ersten Anschluß des neunten Feldeffekttransistors (P 9') zweiten Typs aufgeschaltet ist, daß ein zweiter Anschluß des neunten Feldeffekttransistors zweiten Typs (P9') mit einem ersten Anschluß des zehnten Feldeffekttransistors zweiten Typs (P10') verbunden ist und ein zweiter Anschluß des zehnten Feldeffekttransistors zweiten Typs (P10') und zweiter Anschluß des zehnten Feldeffekttransistors ersten Typs (N10') gemeinsam auf einem Gateanschluß des zehnten Feldeffekttransistors ersten Typs (N10') aufgeschaltet ist, daß ein zweiter Anschluß des achten Feldeffekttransistors ersten Typs (N8') den Ausgang des Rückkopplungsnetzwerks (RK') bildet, daß ein Gateanschluß des neunten Feldeffekttransistors zweiten Typs (P9') an einen Ausgang des weiteren Verstärkers (SC') angeschlossen ist, daß der Gateanschluß des zehnten Feldeffekttransistors ersten Typs (N10') auf den Gateanschluß des ersten Feldeffekttransistors ersten Typs (N1'), den Gateanschluß des vierten Feldeffekttransistors ersten Typs (N4') und auf den Gateanschluß des fünften Feldeffekttransistors ersten Typs (N5') aufgeschaltet ist.

13. Kompressionsverstärker nach einem der Ansprüche 5 bis 12, **dadurch gekennzeichnet, daß** der Zweiquadrantenmultiplizierer (ZM') mit vorgeschaltetem Spannungsteiler und der weiteren Zweiquadrantenmulitplizierer (ZM") mit vorgeschaltetem Spannungsteiler jeweils einen ersten Transkonduktanzverstärker (TK1), einen ersten, zweiten, dritten und vierten Widerstand (R1, R2, R3, R4; R1, R2', R3, R4) enthält, daß der erste und zweite Widerstand (R1, R2, R1, R2') in Serie geschaltet sind und den vorgeschalteten Spannungsteiler bilden, daß ein erster Anschluß des Spannungsteilers des Zweiquadrantenmultiplizierers (ZM') der Eingang ($U_e'$; $U_e''$) des Kompressionsverstärkers ist und auf einen ersten Anschluß des Spannungsteilers des weiteren Zweiquadrantenmultiplizierers (ZM") eine Referenzspannung ($U_{REF}$) aufgeschaltet ist und der zweite Anschluß des Spannungsteilers mit Masse (GND) verschaltet ist, daß ein erster Eingang des ersten Transkonduktanzverstärkers (TK1) mit einem Mittenabgriff zwischen dem ersten und zweiten Widerstand (R1, R2, R1, R2') angeschlossen ist, daß ein Ausgang des ersten Transkonduktanzverstärkers (TK1) über den dritten Widerstand (R3) mit einem zweiten Eingang des ersten Transkonduktanzverstärkers (TK1) und über den vierten Widerstand (R4) mit Masse (GND) verbunden ist, daß der Ausgang jeweils des ersten Transkonduktanzverstärkers den Ausgang des Zweiquadrantenmulitplizierers (ZM') sowie des weiteren Zweiquadrantenmultiplizierers (ZM") bildet.

14. Kompressionsverstärker nach Anspruch 13, **dadurch gekennzeichnet, daß** der zweite Widerstand (R2') im vorgeschalteten Spannungsteiler des weiteren Zweiquadrantenmultiplizierers (ZM") einen Widerstandswert aufweist, der halb so hoch ist, wie der Widerstandswert des zweiten Widerstandes (R2) im vorgeschalteten Spannungsteiler des Zweiquadrantenmultiplizierers (ZM').

15. Kompressionsverstärker nach einem der Ansprüche 5 bis 14, **dadurch gekennzeichnet, daß** der weitere Verstärker (SC') einen zweiten Transkonduktanzverstärker (TK2) eine dritte, vierte und fünfte Kapazität (C3, C4, C5), einen ersten, zweiten und dritten Schalter erster Art (S11, S12, S13) und einen ersten, zweiten und dritten Schalter zweiter Art (S21, S22, S23) enthält, daß die dritte Kapazität (C3) einen Kapazitätswert aufweist, der doppelt so hoch ist wie der Kapazitätswert der vierten Kapazität, daß der erste Schalter erster Art (S11) mit dem ersten Schalter zweiter Art (S21) seriell zwischen dem Ausgang des weiteren Zweiquadrantenmultiplizierers (ZM") und Masse (GND) geschaltet ist, wobei Masse (GND) mit dem ersten Schalter zweiter Art (S21) verbunden ist, daß der zweite Schalter erster Art (S12) mit dem zweiten Schalter zweiter Art (S22) seriell zwischen Masse (GND) und einem ersten Eingang des zweiten Transkonduktanzverstärkers (TK2) geschaltet ist, wobei Masse (GND) mit dem zweiten Schalter erster Art (S12) verbunden ist, daß ein dritter Schalter erster Art (S13) und ein dritter Schalter zweiter Art (S23) zwischen Masse (GND) und der Referenzspannung ($U_{REF}$) verschaltet sind, wobei Masse (GND) mit dem dritten Schalter erster Art (S13) verbunden ist, daß die dritte Kapazität (C3) an einem Mittenanschluß zwischen dem ersten Schalter erster Art (S11) und dem ersten Schalter zweiter Art (S21) und einem Mittenanschluß zwischen dem zweiten Anschluß erster Art (S12) und dem zweiten Schalter zweiter Art (S22) geschaltet ist, daß die vierte Kapazität (C4) an einen Mittenanschluß zwischen dem dritten Schalter erster Art (S13) und dem dritten Schalter zweiter Art (S23) und einem Mittenanschluß zwischen dem zweiten Schalter erster Art (S12) und einem zweiten Schalter zweiter Art (S22) angeschlossen ist, daß ein Ausgang des zweiten Transkonduktanzverstärkers (TK2) der einen Ausgang des weiteren Verstärkers (SC') bildet über eine fünfte Kapazität (C5) auf den ersten Eingang des zweiten Transkonduktanzverstärkers (TK2) rückgekoppelt ist, daß ein zweiter Eingang des zweiten Transkonduktanzverstärkers (TK2) mit Masse (GND) verschaltet ist.

16. Kompressionsverstärker nach einem der Ansprüche 1 bis 15, **dadurch gekennzeichnet,** daß zwischen dem Zweiquadrantenmultiplizierer (ZM') und dem Ausgang ($U_a'$; $U_a''$) des Kompressionsverstärkers ein Trennverstärker (TV) geschaltet ist, daß der Trennverstärker (TV) einen dritten Transkonduktanzverstärker (TK3) eine sechste, siebte und achte Kapazität (C6, C7, C8) und einen vierten, fünften und sechsten Schalter erster Art (S14, S15, S16) und einen vierten, fünften und sechsten Schalter zweiter Art (S24, S25, S26) enthält, daß der vierte Schalter erster Art (S14) zwischen dem Zweiquadrantenmultiplizierer (ZM') und einem ersten Anschluß der sechsten Kapazität (C6) geschaltet ist, daß zwischen dem ersten Anschluß der sechsten Kapazität (C6) und Masse (GND) der vierte Schalter zweiter Art (S24) angeschlossen ist, daß ein zweiter Anschluß der sechsten Kapazität (C6) mit einem ersten Anschluß des dritten Transkonduktanzverstärkers (TK3) und der fünfte Schalter erster Art (S15) und der fünfte Schalter zweiter Art (S25), die seriell miteinander verbunden sind, zwischen dem zweiten Anschluß der sechsten Kapazität (C6) und Masse (GND) geschaltet sind, wobei der fünfte Schalter zweiter Art (S25) mit Masse (GND) verschaltet ist, daß ein Ausgang des dritten Transkonduktanzverstärkers (TK3) der einen Ausgang des Trennverstärkers (TV) bildet über die siebte Kapazität (C7) auf einen Mittenanschluß zwischen dem fünften Schalter erster Art (S15) und fünften Schalter zweiter Art (S25) rückgekoppelt ist, daß der sechste Schalter erster Art (S16) und der sechste Schalter zweiter Art (S26) seriell zwischen Masse (GND) und dem Ausgang des dritten Transkonduktanzverstärkers (TK3) geschaltet ist, wobei der sechste Schalter erster Art (S16) mit Masse (GND) verbunden ist, und ein erster Anschluß der achten Kapazität (C8) an einen Mittenabgriff zwischen dem sechsten Schalter erster Art (S16) und sechsten Schalter zweiter Art (S26) und ein zweiter Anschluß der achten Kapazität (C8) auf den ersten Eingang des dritten Transkonduktanzverstärkers (TK3) geschaltet ist, und daß ein zweiter Eingang des dritten Transkonduktanzverstärkers (TK3) mit Masse (GND) verbunden ist.

17. Kompressionsverstärker nach Anspruch 14 oder 15, **dadurch gekennzeichnet,** daß die Schalter erster Art und Schalter zweiter Art Transmissionsgates darstellen und mit einem Zweiphasentakt angesteuert werden, und daß die Schalter dritter Art als programmierbare Ein/Ausschalter realisiert sind.

18. Kompressionsverstärker nach einem der vorhergehenden Ansprüche, **dadurch gekennzeichnet,** daß die Feldeffekttransistoren ersten Typs n-Kanal-Feldeffekttransistoren und die Feldeffekttransistoren zweiten Typs p-Kanal-Feldeffekttransistoren sind und der erste Bezugspunkt mit einer negativen Versorgungsspannung und der zweite Bezugspunkt mit einer positiven Versorgungsspannung verbunden ist.

19. Verwendung eines Kompressionsverstärkers nach einem der vorhergehenden Ansprüche,
    **dadurch gekennzeichnet,**
    daß dieser in Hinterohr-Höhrgeräten eingesetzt wird, bei denen ein eingeschränkter Dynamikbereich ausgeglichen wird.

## Claims

1. Compression amplifier having a two-quadrant multiplier (ZM', ZM'') and a feedback path which contains a rectifier stage (GR', GR'') and a downstream low-pass filter (TP', TP''), in which one output from the low-pass filter (TP', TP'') is fed back to the two-quadrant multiplier (ZM', ZM'') and the two-quadrant multiplier (ZM', ZM'') is connected with an upstream voltage divider between an input to and an output ($U_e'$, $U_a'$, $U_e''$, $U_a''$) from the compression amplifier, in which an amplifier having variable gain (SC) is connected in the feedback path between the rectifier stage (GR', GR'') and the output ($U_a'$, $U_a''$) from the compression amplifier and in which the rectifier stage (GR' GR'') is assigned a circuit for bias-voltage production (GV, GV'), characterized in that the transistors which are contained in the compression amplifier are designed in the form of field-effect transistors (P1, P1' ... P10, P10', N1, N1' ... N10, N10'), in that the amplifier having variable gain (SC) is a "switched capacitor" amplifier which contains a seventh, eighth and ninth switch of a first type (S17, S18, S19), a seventh, eighth and ninth switch of a second type (S27, S28, S29) and a first, second, third and fourth switch of a third type (S31, S32, S33, S34), a ninth, tenth, eleventh, twelfth, thirteenth and fourteenth capacitor (C9, C10, C11, C12, C13, C14) and a fourth transconductance amplifier (TK4), the switches of the first type being controlled in a push-pull manner with respect to the switches of the second type, and the switches of the third type being independent of the switches of the first and second type, in that a parallel capacitor network and the seventh switch of the second type (S27) are arranged in series between a first input to the fourth transconductance amplifier (TK4) and the input to the amplifier having variable gain (SC), in that the seventh switch of the first type (S17) is arranged between the centre tap between the parallel capacitor network and the seventh switch of the second type (S27) on the one hand and earth (GND) on the other hand, in that the parallel capacitor network contains the ninth capacitor (C9) connected in series with the first switch of the third type (S31), this series circuit being connected in parallel with the tenth capacitor (C10), which is connected in series with the second switch of the third type (S32), in parallel with the eleventh capacitor (C11), which is connected in series with the third switch of the third type (S33), and in parallel with the twelfth capacitor (C12), which is connected in series with the fourth switch of the fourth type (S34), in that one output from the fourth transconductance amplifier (TK4), which at the same time forms the output from the amplifier having variable gain (SC) is fed back via a thirteenth capacitor (C13) in series with the eighth switch of the second type (S28) and via the ninth switch of the first type (S19) in series with the fourteenth capacitor (C14) to the first input to the fourth transconductance amplifier (TK4), in that a second input to the fourth transconductance amplifier (TK4) is connected to earth (GND), in that an eighth switch of the first type (S18) is connected between earth (GND) and a centre tap between the eighth switch of the second type (S28) and the thirteenth capacitor (C13), and in that a ninth switch of the second type (S29) is arranged between earth (GND) and a centre tap between the ninth switch of the first type (S19) and the fourteenth capacitor (C14).

2.  Compression amplifier according to Claim 1, characterized in that a reference current source (RI) is connected to a summation point (S) between the low-pass filter (TP′) and the rectifier stage (GR′) .

3.  Compression amplifier according to Claim 2, characterized in that the circuit for bias-voltage production (GV) contains a first field-effect transistor of the first type (N1) and a first and a second field-effect transistor of the second type (P1, P2), and a gate connection of the first field-channel field-effect transistor of the second type (P1) and a first connection of the first field-effect transistor (N1) of the first type are jointly connected to a first reference point ($V_{SS}$), a second connection of the first field-effect transistor (N1) of the first type and a first connection of the second field-effect transistor of the second type (P2) are jointly connected to a gate connection of the second field-effect transistor of the second type (P2) and to a first input to the first field-effect transistor of the second type (P1), in that a second connection of the second field-effect transistor of the second type (P2) is connected to a second reference point ($V_{DD}$), and a second connection of the first field-effect transistor of the second type (P1) is connected to the rectifier stage (GR′), in that the reference current source (RI) contains a second field-effect transistor of the first type (N2) and a reference bias-voltage circuit (RVU), in that a first input to the second field-effect transistor of the first type (N2) is connected to the first reference point ($V_{SS}$), and a second input to the second field-effect transistor of the first type (N2) is connected to the summation point, in that a gate connection of the first field-effect transistor of the first type (N1) and a gate connection of the second field-effect transistor of the first type (N2) are connected to the reference bias-voltage circuit (RVU).

4.  Compression amplifier according to Claim 3, characterized in that the rectifier stage (GR′) contains a third field-effect transistor of the second type (P3) and a first capacitor (C1), in that the first capacitor (C1) is jointly connected, between an output from the amplifier having variable gain (SC) and a gate connection of the third field-effect transistor of the second type (P3), to the second connection of the first field-effect transistor of the second type (P1) from the circuit for bias-voltage production (GV), and in that a first connection of the third field-effect transistor of the second type (P3) is connected to the second reference point ($V_{DD}$), and a second connection of the third field-effect transistor of the second type (P3) is connected to the summation point (S).

5.  Compression amplifier according to Claim 3 or 4, characterized in that the reference bias-voltage circuit (RVU) contains a further two-quadrant multiplier (ZM″) with an upstream voltage divider and a feedback path which is connected to the output from the further two-quadrant multiplier (ZM″), in that a further amplifier (SC′) and a downstream feedback network (RK) are installed in the feedback path, in that an output from the feedback network (RK) is fed back to the further two-quadrant multiplier (ZM″), in that the feedback network (RK) contains a third and a fourth field-effect transistor of the first type (N3, N4) and a fourth and a fifth field-effect transistor of the second type (P4, P5), in that a first connection of the third field-effect transistor of the first type (N3), a first connection of the fourth field-effect transistor of the first type (N4) and a gate connection of the fifth field-effect transistor of the second type (P5) are connected to the first reference point ($V_{SS}$), in that a first connection of the fifth field-effect transistor of the second type (P5) is connected to the second reference point ($V_{DD}$) and a second connection of the fifth field-effect transistor of the second type (P5) is connected to a first connection of the fourth field-effect transistor of the second type (P4), in that a second connection of the fourth field-effect transistor of the second type (P4), a second connection and a gate connection in each case of the fourth field-effect transistor of the first type (N4) are connected to a gate connection of the third field-effect transistor of the first type (N3) and to the gate connections of the first and of the second field-effect transistor of the first type (N1, N2), and in that a second connection of the third field-effect transistor of the first type (N3) forms the output from the feedback network (RK), and a gate connection of the fourth field-effect transistor of the second type (P4) is connected to an output from the further amplifier having variable gain (SC′).

6. Compression amplifier according to one of Claims 2 to 5, characterized in that the low-pass filter (TP′) contains a second capacitor (C2), a fifth and a sixth field-effect transistor of the first type (N5, N6) and a sixth and a seventh field-effect transistor of the second type (P6, P7), in that a first input to the sixth field-effect transistor of the second type (P6) and a first input to the seventh field-effect transistor of the second type (P7) are connected to the second reference point ($V_{DD}$), in that a first connection of the fifth field-effect transistor of the first type (N5) and a first connection of the sixth field-effect transistor of the first type (N6) are connected to a first reference point ($V_{SS}$), and a gate connection of the fifth field-effect transistor of the first type (N5), and a gate connection of the sixth field-effect transistor of the first type (N6) are jointly connected to a second input to the sixth field-effect transistor of the second type (P6) and to a second connection of the sixth field-effect transistor of the first type (N6), in that a second connection of the fifth field-effect transistor of the first type (N5) forms the output from the low-pass filter (TP′), and the second capacitor (C2) is connected between the first reference point ($V_{SS}$) and a second connection of the seventh field-effect transistor of the second type (P7), in that the second connection of the seventh field-effect transistor of the second type (P7) is connected to the summation point (S) and to a gate connection of the sixth field-effect transistor of the second type (P6) and to a gate connection of the seventh field-effect transistor of the second type (P7).

7. Compression amplifier according to Claim 1, characterized in that the low-pass filter (TP″) is fed back via a voltage/current convertor (U/IW) to the two-quadrant multiplier (ZM′), in that the voltage/current convertor (U/IW) is assigned a reference voltage source (RU) which has a reference voltage differing from the supply voltages ($V_{DD}$, $V_{SS}$).

8. Compression amplifier according to Claim 7, characterized in that the circuit for bias-voltage production (GV′) contains a first, a second, a third and a fourth field-effect transistor of the second type (P1′, P2′, P3′, P4′) and a first and a second field-effect transistor of the first type (N1′, N2′), in that a gate connection of the first field-effect transistor of the second type (P1′) and a first connection of the first field-effect transistor of the first type (N1′) are jointly connected to a first reference point ($V_{SS}$), in that a first connection of the first field-effect transistor of the second type (P1′) and a first connection of the second field-effect transistor of the first type (N2′) are jointly connected to a gate connection of the second field-effect transistor of the first type (N2′), in that a second connection of the second field-effect transistor of the first type (N2′) and a second connection of the first field-effect transistor of the first type (N1′) are jointly connected to a first input to the second field-effect transistor of the second type (P2′) and to a gate connection of the second field-effect transistor of the second type (P2′), in that a second input to the second field-effect transistor of the second type is connected to a first input to the third field-effect transistor of the second type (P3′), and to a gate connection of the third and of the fourth field-effect transistor of the second type (P3′, P4′), in that a first connection of the second field-effect transistor of the first type (N2′) is connected to a first connection of the fourth field-effect transistor of the second type (P4′), and a second connection of the third field-effect transistor of the second type (P3′) and a second connection of the fourth field-effect transistor of the second type (P4′) are connected to the second reference point ($V_{DD}$), and in that a second connection of the first field-effect transistor of the second type (P1′) is connected to the rectifier stage (GR′).

9. Compression amplifier according to Claim 8, characterized in that the rectifier stage (GR″) contains a third field-effect transistor of the first type (N3′) and a first capacitor (C1′), in that the first capacitor (C1′) is connected between an output from the amplifier having variable gain (SC) and a gate connection of the third field-effect transistor of the first type (N3') and a second connection of the first field-effect transistor of the second type (P1') from the circuit for bias-voltage production (GV'), in that a first connection of the third field-effect transistor of the first type (N3') is connected to the second reference point ($V_{DD}$), and a second connection of the third field-effect transistor of the first type (N3') is connected to the low-pass filter (TP'').

10. Compression amplifier according to one of Claims 7, 8 or 9, characterized in that the low-pass filter (TP'') contains a second capacitor (C2') and a fourth field-effect transistor of the first type (N4'), in that a first connection of the second capacitor (C2') and a first connection of the fourth field-effect transistor of the first type (N4') are jointly connected to the rectifier stage (GR''), and a second connection of the second capacitor (C2') and a second connection of the fourth field-effect transistor of the first type (N4') are jointly connected to the first reference point ($V_{SS}$), and the first connection of the second capacitor (C2') and the first connection of the fourth field-effect transistor of the first type (N4') jointly form an output from the low-pass filter (TP'').

11. Compression amplifier according to one of Claims 7 to 10, characterized in that the voltage/current convertor (U/IW) contains a fifth, a sixth and a seventh field-effect transistor of the first type (N5', N6', N7') and a fourth, a fifth and a sixth field-effect transistor of the second type (P4', P5', P6'), in that a first connection of the fifth field-effect transistor of the first type (N5'), a first connection of the sixth field-effect transistor of the first type (N6') and a first connection of the seventh field-effect transistor of the first type (N7') are jointly connected to the first reference point ($V_{SS}$), in that a first connection of the fourth field-effect transistor of the second type (P4') and a first connection of the fifth field-effect transistor of the second type (P5') are connected to the second reference point ($V_{DD}$), in that a gate connection of the sixth field-effect transistor of the first type (N6') and a gate connection of the seventh field-effect transistor of the first type (N7') are jointly connected to a second connection of the seventh field-effect transistor of the first type (N7') and to a second connection of the fourth field-effect transistor of the second type (P4'), in that a gate connection of the fourth field-effect transistor of the second type (P4') and a gate connection of the fifth field-effect transistor of the second type (P5') are jointly connected to a second input to the fifth field-effect transistor of the second type (P5') and to a first input to the sixth field-effect transistor of the second type (P6'), in that a second connection of the sixth field-effect transistor of the second type (P6') is connected to a second connection of the fifth field-effect transistor of the first type (N5'), and in that a gate connection of the sixth field-effect transistor of the second type (P6') is connected to the low-pass filter (TP'), and a second connection of the sixth field-effect transistor of the first type (N6') is fed back to the two-quadrant multiplier (ZM').

12. Compression amplifier according to Claim 11, characterized in that the reference voltage source (RU) contains a further two-quadrant multiplier (ZM'') having an upstream voltage divider and a feedback path which is connected to the output from the further two-quadrant multiplier (ZM''), in that a further amplifier (SC') and a downstream feedback network (RK') are installed in the feedback path, in that an output from the feedback network (RK') is fed back to the further two-quadrant multiplier (ZM''), in that the feedback network (RK') contains an eighth, a ninth and a tenth field-effect transistor of the first type (N8', N9', N10') and a seventh, an eighth, a ninth and a tenth field-effect transistor of the second type (P7', P8', P9', P10'), in that a first connection of the eighth field-effect transistor of the first type (N8'), a first connection of the ninth field-effect transistor of the first type (N9'), a first connection of the tenth field-effect transistor of the first type (N10') and a gate connection of the tenth field-effect transistor of the second type (P10') are jointly connected to the first reference point ($V_{SS}$), in that a gate connection of the eighth field-effect transistor of the first type (N8') and a gate connection of the ninth field-effect transistor of the first type (N9') are jointly connected to a second connection of the ninth field-effect transistor of the first type (N9') and to a first connection of the seventh field-effect transistor of the second type (P7'), in that a second connection of the seventh field-effect transistor of the second type (P7') is connected to a first connection of the eighth field-effect transistor of the second type (P8') and jointly to the second reference point ($V_{DD}$), in that a gate connection of the seventh field-effect transistor of the second type (P7') and a gate connection of the eighth field-effect transistor of the second type (P8') are jointly connected to a second connection of the eighth field-effect transistor of the second type (P8') and to a first connection of the ninth field-effect transistor (P9') of the second type, in that a second connection of the ninth field-effect transistor of the second type (P9') is connected to a first connection of the tenth field-effect transistor of the second type (P10'), and a second connection of the tenth field-effect transistor of the second type (P10') and a second connection of the tenth field-effect transistor of the first type (N10') are jointly con-

EP 0 363 714 B1

nected to a gate connection of the tenth field-effect transistor of the first type (N10′), in that a second connection of the eighth field-effect transistor of the first type (N8′) forms the output from the feedback network (RK′), in that a gate connection of the ninth field-effect transistor of the second type (P9′) is connected to an output from the further amplifier (SC′) and in that the gate connection of the tenth field-effect transistor of the first type (N10′) is connected to the gate connection of the first field-effect transistor of the first type (N1′), to the gate connection of the fourth field-effect transistor of the first type (N4′) and to the gate connection of the fifth field-effect transistor of the first type (N5′).

13. Compression amplifier according to one of Claims 5 to 12, characterized in that the two-quadrant multiplier (ZM′) having an upstream-connected voltage divider, and the further two-quadrant multiplier (ZM″) having an upstream-connected voltage divider each contain a first transconductance amplifier (TK1), and a first, a second, a third and a fourth resistor (R1, R2, R3, R4; R1, R2′, R3, R4), in that the first and the second resistor (R1, R2, R1, R2′) are connected in series and form the upstream-connected voltage divider, in that a first connection of the voltage divider of the two-quadrant multiplier (ZM′) is the input ($U_e$′; $U_e$″) to the compression amplifier, and a reference voltage ($U_{REF}$) is connected to a first connection of the voltage divider of the further two-quadrant multiplier (ZM″), and the second connection of the voltage divider is connected to earth (GND), in that a first input to the first transconductance amplifier (TK1) is connected by means of a centre tap between the first and the second resistor (R1, R2, R1, R2′), in that an output from the first transconductance amplifier (TK1) is connected via the third resistor (R3) to a second input to the first transconductance amplifier (TK1) and via the fourth resistor (R4) to earth (GND), and in that the output from the first transconductance amplifier in each case forms the output from the two-quadrant multiplier (ZM′) and from the further two-quadrant multiplier (ZM″).

14. Compression amplifier according to Claim 13, characterized in that the second resistor (R2′) in the upstream-connected voltage divider of the further two-quadrant multiplier (ZM″) has a resistance value which is half as great as the resistance value of the second resistor (R2) in the upstream-connected voltage divider of the two-quadrant multiplier (ZM′).

15. Compression amplifier according to one of Claims 5 to 14, characterized in that the further amplifier (SC′) contains a second transconductance amplifier (TK2), a third, a fourth and a fifth capacitor (C3, C4, C5), a first, a second and a third switch of the first type (S11, S12, S13) and a first, a second and a third switch of the second type (S21, S22, S23), in that the third capacitor (C3) has a capacitance value which is twice as great as the capacitance value of the fourth capacitor, in that the first switch of the first type (S11) is connected with the first switch of the second type (S21) in series between the output from the further two-quadrant multiplier (ZM″) and earth (GND), earth (GND) being connected to the first switch of the second type (S21), in that the second switch of the first type (S12) is connected with the second switch of the second type (S22) in series between earth (GND) and a first input to the second transconductance amplifier (TK2), earth (GND) being connected to the second switch of the first type (S12), in that a third switch of the first type (S13) and a third switch of the second type (S23) are connected between earth (GND) and the reference voltage ($U_{REF}$), earth (GND) being connected to the third switch of the first type (S13), in that the third capacitor (C3) is connected to a centre connection between the first switch of the first type (S11) and the first switch of the second type (S21) and a centre connection between the second connection of the first type (S12) and the second switch of the second type (S22), in that the fourth capacitor (C4) is connected to a centre connection between the third switch of the first type (S13) and the third switch of the second type (S23) and a centre connection between the second switch of the first type (S12) and a second switch of the second type (S22), in that an output from the second transconductance amplifier (TK2) forms one output from the further amplifier (SC′) and is fed back via a fifth capacitor (C5) to the first input to the second transconductance amplifier (TK2), and in that a second input to the second transconductance amplifier (TK2) is connected to earth (GND).

16. Compression amplifier according to one of Claims 1 to 15, characterized in that an isolating amplifier (TV) is connected between the two-quadrant multiplier (ZM′) and the output ($U_a$′; $U_a$″) from the compression amplifier, in that the isolating amplifier (TV) contains a third transconductance amplifier (TK3), a sixth, a seventh and an eighth capacitor (C6, C7, C8) and a fourth, a fifth and a sixth switch of the first type (S14, S15, S16) and a fourth, a fifth and a sixth switch of the second type (S24, S25, S26), in that the fourth switch of the first type (S14) is connected between the two-quadrant multiplier (ZM′) and a first connection of the sixth capacitor (C6), in that the fourth switch of the second type (S24) is connected between the first connection of the sixth capacitor (C6) and earth (GND), in that a second connection of the sixth ca-

20

pacitor (C6) is connected to a first connection of the third transconductance amplifier (TK3), and the fifth switch of the first type (S15) and the fifth switch of the second type (S25), which are connected to one another in series, are connected between the second connection of the sixth capacitor (C6) and earth (GND), the fifth switch of the second type (S25) being connected to earth (GND), in that an output from the third transconductance amplifier (TK3) which forms an output from the isolating amplifier (TV) is fed back via the seventh capacitor (C7) to a centre connection between the fifth switch of the first type (S15) and the fifth switch of the second type (S25), in that the sixth switch of the first type (S16) and the sixth switch of the second type (S26) are connected in series between earth (GND) and the output from the third transconductance amplifier (TK3), the sixth switch of the first type (S16) being connected to earth (GND), and a first connection of the eighth capacitor (C8) is connected to a centre tap between the sixth switch of the first type (S16) and the sixth switch of the second type (S26), and a second connection of the eighth capacitor (C8) is connected to the first input to the third transconductance amplifier (TK3), and in that a second input to the third transconductance amplifier (TK3) is connected to earth (GND).

17. Compression amplifier according to Claim 14 or 15, characterized in that the switches of the first type and the switches of the second type represent transmission gates and are driven by a two-phase clock, and in that the switches of the third type are implemented as programmable on/off switches.

18. Compression amplifier according to one of the preceding claims, characterized in that the field-effect transistors of the first type are n-channel field-effect transistors and the field-effect transistors of the second type are p-channel field-effect transistors, and the first reference point is connected to a negative supply voltage, and the second reference point is connected to a positive supply voltage.

19. Use of a compression amplifier according to one of the preceding claims, characterized in that said compression amplifier is used in behind-the-ear hearing aids in which a limited dynamic range is compensated for.

**Revendications**

1. Amplificateur de compression comportant un multiplicateur fonctionnant dans deux quadrants (ZM',ZM") et une branche de réaction à un étage redresseur (GR',GR") et à un filtre passe-bas (TP',TP") branché en aval, et dans lequel

une sortie du filtre passe-bas (TP',TP") est couplée par réaction au multiplicateur fonctionnant dans deux quadrants (ZM',ZM"), et le multiplicateur fonctionnant dans deux quadrants (ZM',ZM") est raccordé à un diviseur de tension branché en amont, entre une entrée et une sortie $(U_e',U_a',U_e'',U_a'')$ de l'amplificateur de compression,

un amplificateur à amplification variable (SC) est branché, dans la branche de réaction, entre l'étage redresseur (GR',GR3) et la sortie $(U_a',U_a'')$ de l'amplificateur de compression, et un circuit (GV,GV') de production d'une tension de polarisation est associé à l'étage redresseur (GR',GR"),

caractérisé par le fait

que les transistors contenus dans l'amplificateur de compression sont réalisés sous la forme de transistors à effet de champ (P1,P1'...P10,P10',N1,N1'....N10,N10'),

que l'amplificateur à amplification variable (SC) est un amplificateur "switched capacitor", qui comporte des septième, huitième et neuvième interrupteurs d'un premier type (S17,S18,S19), des septième, huitième et neuvième interrupteurs d'un second type (S27,S28,S29) et des premier ou second, troisième ou quatrième interrupteurs d'un troisième type (S31,S32,S33,S34), des neuvième, dixième, onzième, douzième, treizième et quatorzième capacités (C9, C10,C11,C12,C13,C14) et un quatrième amplificateur à transconductance (TK4), les interrupteurs du premier type étant commandés en opposition de phase par rapport aux interrupteurs du second type, et les interrupteurs du treizième type étant indépendants des interrupteurs des premier et second types,

qu'entre une première entrée du troisième amplificateur à transductance (TK4) et l'entrée de l'amplificateur à amplification variable (SC) sont branchés en série un réseau parallèle de capacités et le septième interrupteur du second type (S27),

que le septième interrupteur du premier type (S17) est disposé entre la prise médiane située entre le réseau parallèle de capacités et le septième interrupteur du second tpye (S27), d'une part, et la masse (GND), d'autre part,

que le réseau parallèle de capacités contient la neuvième capacité (C9) branchée en série avec le premier interrupteur du troisième type (S31), en parallèle avec la dixième capacité (C10) branchée en série avec le second interrupteur du troisième type (S32), en parallèle avec la onzième capacité (C11) branchée en série avec le troisième interrupteur du troisième type (S33), en parallèle avec la deuxième capacité (C12) branchée en série avec le quatrième interrupteur du quatrième type (S34),

qu'une sortie du quatrième amplificateur à transconductance (TK4), qui forme simultanément la sortie de l'amplificateur à amplification variable (SC), est couplée par réaction avec la première entrée du quatrième amplificateur à transconductance (TK4), par l'intermédiaire d'une treizième capacité (C13) en série avec le huitième interrupteur du second type (S28) ainsi que par l'intermédiaire du neuvième interrupteur du premier type (S19) en série avec la quatorzième capacité (C14),

qu'une seconde entrée du quatrième amplificateur à transconductance (TK4) est reliée à la masse (GND), qu'un huitième interrupteur du premier type (S18) est branché entre la masse (GND) et une prise médiane située entre le huitième interrupteur du second type (S28) et la treizième capacité (C13), et

qu'un neuvième interrupteur du second type (S22) est branché entre la masse (GND) et une prise médiane située entre le neuvième interrupteur du premier type (S19) et la quatorzième capacité (C14).

2. Amplificateur de compression suivant la revendication 1, caractérisé par le fait qu'une source de courant de référence (RI) est branchée entre le filtre passe-bas (TP') et l'étage redresseur (GR'), au niveau d'un point de sommation (S).

3. Amplificateur de compression suivant la revendication 2, caractérisé par le fait que le circuit (GV) servant à produire la tension de polarisation comporte un premier transistor à effet de champ d'un premier type (N1) et des premier et second transistors à effet de champ d'un second type (P1,P2), et qu'une borne de grille du premier transistor à effet de champ du second type (P1) et une première borne du premier transistor à effet de champ (N1) du premier type sont raccordées en commun à un premier point de référence ($V_{SS}$), qu'une seconde borne du premier transistor à effet de champ (N1) du premier type et une première borne du second transistor à effet de champ du second type (P2) sont raccordées en commun à une borne de grille du second transistor à effet de champ du second type (P2) et à une première entrée du transistor à effet de champ du second type (P1), qu'une seconde borne du second transistor à effet de champ du second type (P2) est reliée à un second point de référence ($V_{DD}$) et qu'une seconde borne du premier transistor à effet de champ du second type (P1) est reliée à l'étage redresseur (GR'), que la source de courant de référence (RI) comporte un second transistor à effet de champ du premier type (N1) et un circuit (RVU) produisant une tension de polarisation de référence, qu'une première entrée du second transistor à effet de champ du premier type (N2) est reliée au premier point de référence ($V_{SS}$) et qu'une seconde entrée du second transistor à effet de champ du premier type (N2) est reliée au point de sommation (S), qu'une borne de grille du premier transistor à effet de champ du premier type (N2) et une borne de grille du second transistor à effet de champ du premier type (N2) sont interconnectées au circuit (RVU) produisant la tension de polarisation de référence.

4. Amplificateur de compression suivant la revendication 3, caractérisé par le fait que l'étage redresseur (VR') comporte un troisième transistor à effet de champ du second type (P3) et une première capacité (C1), que la première capacité (C1) est branchée entre une sortie de l'amplificateur à amplification variable (SC) d'une borne de grille du troisième transistor à effet de champ du second type (P3) conjointement avec la seconde borne du premier transistor à effet de champ du second type (P1) du circuit (GV) de production de la tension de polarisation, qu'une première borne du troisième transistor à effet de champ du second type (P3) est reliée au second point de référence ($V_{DD}$) et qu'une seconde borne du troisième transistor à effet de champ du second type (P3) est reliée au point de sommation (S).

5. Amplificateur de compression suivant la revendication 3 ou 4, caractérisé par le fait que le circuit (RVU) délivrant la tension de polarisation de référence comporte un autre multiplicateur fonctionnant à deux cadences (ZM''), en amont duquel est branché un diviseur de tension, et une branche de réaction, qui est raccordée à la sortie de l'autre multiplicateur fonctionnant sur deux quadrants (ZM''), qu'un autre amplificateur (SC') et un réseau aval de réaction (RK) sont montés dans la branche de réaction, qu'une sortie du réseau de réaction (RK) est couplée par réaction à l'autre multiplicateur fonctionnant sur deux quadrants (ZM''), que le réseau de réaction (RK) comporte des troisième et quatrième transistors à effet de champ du premier type (N3,N4) et des quatrième et cinquième transistors à effet de champ du second type (P4,P5), qu'une première borne du troisième transistor à effet de champ du premier type (N3), une première borne du quatrième transistor à effet de champ du premier type (N4) et une borne de grille du cinquième transistor à effet de champ du second type (P5) sont raccordés au premier point de référence

(V<sub>SS</sub>), qu'une première borne du cinquième transistor à effet de champ du second type (P5) est reliée au second point de référence (V<sub>DD</sub>) et qu'une seconde borne du transistor à effet de champ du second type (P5) est reliée à une première borne du quatrième transistor à effet de champ du second type (P4), qu'une seconde borne du quatrième transistor à effet de champ du second type (P4), une seconde borne et une borne de grille respectivement du quatrième transistor à effet de champ du premier type (N4) sont reliées à une borne de grille du troisième transistor à effet de champ du premier type (N3) et aux bornes de grille des premier et second transistors à effet de champ du premier type (N1,N2), qu'une seconde borne du troisième transistor à effet de champ du premier type (N3) forme la sortie du réseau de réaction (RK) et qu'une borne de grille du quatrième transistor à effet de champ du second type (P4) est raccordée à une sortie de l'autre amplificateur à amplification variable (SC′).

6. Amplificateur de compression suivant l'une des revendications 2 à 5, caractérisé par le fait que le filtre passe-bas (TP′) comporte une seconde capacité (C2), des cinquième et sixième transistors à effet de champ du premier type (N5,N6) et des sixième et septième transistors à effet de champ du second type (P6,P7), qu'une première entrée du sixième transistor à effet de champ du second type (P6) et une première entrée du septième transistor à effet de champ du second type (P7) sont raccordées au second point de référence (V<sub>DD</sub>), qu'une première borne du cinquième transistor à effet de champ du premier type (N5) et une première borne du sixième transistor à effet de champ du premier type (N6) sont raccordées au premier point de référence (V<sub>SS</sub>), et qu'une borne de grille du cinquième transistor à effet de champ du premier type (N5) et une borne de grille du sixième transistor à effet de champ du premier type (N6) sont raccordées en commun à une seconde entrée du sixième transistor à effet de champ du second type (P6) à une seconde borne du sixième transistor à effet de champ du premier type (N6), qu'une seconde borne du cinquième transistor à effet de champ du premier type (N5) forme la sortie du filtre passe-bas (TP′) et que la seconde capacité (C2) est reliée entre le premier point de référence (V<sub>SS</sub>) et une seconde borne du septième transistor à effet de champ du second type (P7), que la seconde borne du septième transistor à effet de champ du second type (P7) est reliée au point de sommation (S) et à une borne de grille du sixième transistor à effet de champ (P6) à une borne de grille du septième transistor à effet de champ (P7).

7. Amplificateur de compression suivant la revendication 1, caractérisé par le fait que le filtre passe-bas (TP″) est couplé par réaction au multiplicateur fonctionnant dans deux quadrants (ZUM′) par l'intermédiaire d'un convertisseur tension/courant (U/IW), et qu'au convertisseur tension/courant (U/IW) est associée une source de tension de référence (RU), qui possède une tension de référence qui diffère de la tension d'alimentation (V<sub>DD</sub>,V<sub>SS</sub>).

8. Amplificateur de compression suivant la revendication 7, caractérisé par le fait que le circuit (GV′) servant à produire une tension de polarisation comporte des premier, second, troisième et quatrième transistors à effet de champ d'un second type (P1′,P2′,P3′,P4′) et des premier et second transistors à effet de champ du premier type (N1′, N2′), qu'une borne de grille du premier transistor à effet de champ du second type (P1′) et une première borne du premier transistor à effet de champ du premier type (N1′) sont raccordées en commun à un premier point de référence (V<sub>SS</sub>), qu'une première borne du premier transistor à effet de champ (P1′) et une première borne du second transistor à effet de champ du premier type (N2′) sont raccordées en commun à une borne de grille du second transistor à effet de champ du premier type (N2′), qu'une seconde borne du second transistor à effet de champ du premier type (N2′) et une seconde borne du premier transistor à effet de champ du premier type (N1′) sont raccordées en commun à une première entrée du second transistor à effet de champ du second type (P2′) et à une borne de grille du second transistor à effet de champ du second type (P2′), qu'une seconde entrée du second transistor à effet de champ du second type est reliée à une première entrée du troisième transistor à effet de champ du second type (P3′) et une borne de grille des troisième et quatrième transistors à effet de champ du second type (P3′,P4′), qu'une première borne du second transistor à effet de champ du premier type (N2′) est reliée à une première borne du quatrième transistor à effet de champ du second type (P4′) et qu'une seconde borne du troisième transistor à effet de champ du second type (P3′) et une seconde borne du quatrième transistor à effet de champ du second type (P4′) est reliée au second point de référence (V<sub>DD</sub>), et qu'une seconde borne du premier transistor à effet de champ du second type (P1′) est reliée à l'étage redresseur (GR′).

9. Amplificateur de compression suivant la revendication 8, caractérisé par le fait que l'étage redresseur (GR″) comporte un troisième transistor à effet de champ du premier type (N3′) et une première capacité (C1'), que la première capacité (C1') est branchée entre une sortie de l'amplificateur à amplification variable (SC) et une borne de grille du troisième transistor à effet de champ du premier type (N3') et une seconde borne du premier transistor à effet de champ du second type (P1') du circuit (GV') de production de la tension de polarisation, une première borne du troisième transistor à effet de champ du premier type (N3') est reliée au second point de référence ($V_{DD}$) et qu'une seconde borne du troisième transistor à effet de champ du premier type (N3') est reliée au filtre passe-bas (TP'').

10. Amplificateur de compression suivant l'une des revendications 7, 8 ou 9, caractérisé par le fait que le filtre passe-bas (TP'') comporte une seconde capacité (C2') et le quatrième transistor à effet de champ du premier type (N4'), qu'une première borne de la seconde capacité (C2') et une première borne du quatrième transistor à effet de champ du premier type (N4') sont reliées en commun à l'étage redresseur (GR'') et qu'une seconde borne de la seconde capacité (C2') et une seconde borne du quatrième transistor à effet de champ du premier type (N4') sont reliées en commun au premier point de référence ($V_{SS}$), et que la première borne de la seconde capacité (C2') et la première borne du quatrième transistor à effet de champ du premier type (N4') forment en commun une sortie du filtre passe-bas (TP'').

11. Amplificateur de compression suivant l'une des revendications 7 à 10, caractérisé par le fait que le convertisseur tension/courant (U/IW) comporte des cinquième, sixième et septième transistors à effet de champ du premier type (N5',N6',N7') et des quatrième, cinquième et sixième transistors à effet de champ du second type (P4',P5', P6'), une première borne du cinquième transistor à effet de champ du premier type (25'), une première borne du sixième transistor à effet de champ du premier type (N6') et une première borne du septième transistor à effet de champ du premier type (N7') sont reliées en commun au premier point de référence ($V_{SS}$), qu'une première borne du quatrième transistor à effet de champ du second type (P4') et une première borne du cinquième transitor à effet de champ du second type (P5') sont reliées au second point de référence ($V_{DD}$), qu'une borne de grille du sixième transistor à effet de champ du premier type (N6') et une borne de grille du septième transistor à effet de champ du premier type (N7') sont reliées en commun à une seconde borne du septième transistor à effet de champ du premier type (N7') et à une seconde borne du quatrième transistor à effet de champ du second type (P4'), qu'une borne de grille du quatrième transistor à effet de champ du second type (P4') et une borne de grille du cinquième transistor à effet de champ du second type (P5') sont reliées en commun à une seconde entrée du cinquième transistor à effet de champ du second type (P5') et à une première entrée du sixième transistor à effet de champ du second type (P6'), qu'une seconde borne du sixième transistor à effet de champ du second type (P6') est reliée à une seconde borne du cinquième transistor à effet de champ du premier type (N5'), qu'une borne de grille du sixième transistor à effet de champ du second type (P6') est reliée au filtre passe-bas (TP') et qu'une seconde borne du sixième transistor à effet de champ du premier type (N6') est couplée par réaction au multiplicateur fonctionnant sur deux quadrants (ZM').

12. Amplificateur de compression suivant la revendication 11, caractérisé par le fait que la source de tension de référence (RU) comporte un second multiplicateur fonctionnant dans deux quadrants (ZM''), en aval duquel est branché un diviseur de tension, et une branche de réaction raccordée à la sortie de l'autre multiplicateur fonctionnant dans deux quadrants (ZM''), que dans la branche de réaction sont montés un autre amplificateur (SC') et un réseau de réaction (RK') branché en aval, qu'une sortie du réseau de réaction (RK') est couplée par réaction au second multiplicateur fonctionnant sur deux quadrants (ZM''), que le réseau de réaction (RK') comporte des huitième, neuvième et dixième transistors à effet de champ du premier type (N8', N9', N10') et des septième, huitième, neuvième et dixième transistors à effet de champ du second type (P7',P8',P9', P10'), qu'une première borne du sixième transistor à effet de champ du premier type (N8'), une première borne du neuvième transistor à effet de champ du premier type (N9'), une première borne du dixième transistor à effet de champ du premier type (N10') et une borne de grille du dixième transistor à effet de champ du second type (P10') sont reliées en commun au premier point de référence ($V_{SS}$), qu'une borne de grille du huitième transistor à effet de champ du premier type (N8') et une borne de grille du neuvième transistor à effet de champ du premier type (N9') sont reliées en commun à une seconde borne du neuvième transistor à effet de champ du premier type (N9') et à une première borne du septième transistor à effet de champ du second type (P7'), qu'une seconde borne du septième transistor à effet de champ du second type (P7') est reliée à une première borne du huitième transistor à effet de champ du second type (P8') et en commun au second point de référence ($V_{DD}$), qu'une borne de grille du septième transistor à effet de champ du second type (P7') et une borne de grille du huitième transistor à effet de champ du second type (P8') sont reliées en commun à une seconde borne du huitième transistor à effet de champ du second type (P8') et une première borne du neuvième transistor à effet

24

de champ (P9′) du second type, une seconde borne du neuvième transistor à effet de champ du second type (P9′) est reliée à une première borne du dixième transistor à effet de champ du second type (P10′) et qu'une seconde borne du dixième transistor à effet de champ du second type (P10′) et une seconde borne du dixième transistor à effet de champ du premier type (N10′) sont raccordées en commun à une borne de grille du dixième transistor à effet de champ du premier type (N10′), qu'une seconde borne du huitième transistor à effet de champ du premier type (N8′) forme la sortie du réseau de réaction (RK′), qu'une borne de grille du neuvième transistor à effet de champ du second type (P9′) est raccordée à une sortie de l'autre amplificateur (SC′), que la borne de grille du dixième transistor à effet de champ du premier type (N10′) est raccordée à la borne de grille du premier transistor à effet de champ du premier type (N1′), à la borne de grille du quatrième transistor à effet de champ du premier type (N4′) et à la borne de grille du cinquième transistor à effet de champ du premier type (N5′).

13. Amplificateur de compression suivant l'une des revendications 5 à 12, caractérisé par le fait que le multiplicateur fonctionnant sur deux cadences (ZM′), le long duquel est branché un diviseur de tension, et l'autre multiplicateur fonctionnant sur deux quadrants (ZM″), et en aval duquel est branché un diviseur de tension comportent respectivement un premier amplificateur à transductance (T4), des premier, second, troisième et quatrième résistances (R1,R2,R3,R4; R1,R2′,R3,R4), les première et seconde résistances (R1,R2,R1,R2′) sont branchées en série et forment le diviseur de tension branché en amont, une première borne du diviseur de tension du multiplicateur fonctionnant sur deux quadrants (ZM′) forme l'entrée ($U_e′$; $U_e″$) de l'amplificateur de compression et qu'une tension de référence ($U_{REF}$) est appliquée à une première borne du diviseur de tension de l'autre multiplicateur fonctionnant sur deux quadrants (ZM″) et que la seconde borne du diviseur de tension est raccordée à la masse (GND), qu'une première entrée du premier amplificateur à transconductrance (TK1) est raccordée à une prise médiane située entre les première et seconde résistances (R1,R2,R1,R2′), une sortie du premier amplificateur à transconductance (TK1) est reliée, au moyen de la troisième résistance (R3), à une seconde entrée du premier amplificateur à transconductance (TK1) et par l'intermédiaire de la quatrième résistance (R4) de la masse (GND), que la sortie respectivement du troisième amplificateur à transconductance forme la sortie du multiplicateur fonctionnant sur deux quadrants (ZM′) ainsi que de l'autre multiplicateur fonctionnant sur deux quadrants (ZM″).

14. Amplificateur de compression suivant la revendication 13, caractérisé par le fait que la seconde résistance (R2′) qui est présente dans le diviseur de tension branché en amont du second multiplicateur fonctionnant sur deux quadrants (ZM″) possède une valeur résistive qui est égale à la moitié de la valeur résistive de la seconde résistance (R2) située dans le diviseur de tension, branché en amont, du multiplicateur fonctionnant sur deux quadrants (ZM′).

15. Amplificateur de compression suivant l'une des revendications 5 à 14, caractérisé par le fait que ledit autre amplificateur (SC′) comporte un second amplificateur à transconductance (TK2), des troisième, quatrième et cinquième capacités (C3,C4,C5), des premier, second et troisième interrupteurs du premier type (S11,S12,S13) et des premier, second et troisième interrupteurs du second type (S21,S22, S23), que la troisième capacité (C3) possède une valeur capacitive égale au double de la valeur capacitive de la quatrième capacité, que le premier interrupteur du premier type (S11) est branché en série avec le premier interrupteur du second type (S21) entre la sortie de l'autre multiplicateur fonctionnant sur deux quadrants (ZM″) et la masse (GND), la masse (GND) étant reliée au premier interrupteur du second type (S21), que le second interrupteur du premier type (S12) est branché en série avec le second interrupteur du second type (S22) entre la masse (GND) et une première entrée du second amplificateur à transconductance (TK2), la masse (GND) étant reliée au second interrupteur du premier type (S12), un troisième interrupteur du premier type (S13) et un troisième interrupteur du second type (S23) sont branchés entre la masse (GND) et la tension de référence ($U_{REF}$) la masse (GND) étant reliée au troisième interrupteur du premier type (S13), que la troisième capacité (C3) est raccordée à une borne médiane située entre le premier interrupteur du premier type (S11) et le premier interrupteur du second type (S21) et une borne médiane située entre le second interrupteur du premier type (S12) et le second interrupteur du second type (S22), que la quatrième capacité (C4) est raccordée à une prise médiane située entre le troisième interrupteur du premier type (S13) et le troisième interrupteur du second type (S23) et à une prise médiane située entre le second interrupteur du premier type (S12) et un second interrupteur du second type (S22), qu'une sortie du second amplificateur à transconductance (TK2), qui forme une sortie de l'autre amplificateur (SC′), est couplée par réaction, et par l'intermédiaire d'une cinquième capacité (C5), à la première entrée du second amplificateur à transconductance (TK2), et qu'une seconde entrée du second amplificateur à transconductance (TK2) est reliée à la masse (GN2).

**16.** Amplificateur de compression suivant l'une des revendications 1 à 15, caractérisé par le fait qu'un amplificateur de séparation (TV) est branché entre le multiplicateur fonctionnant sur deux quadrants (ZM') et la sortie ($U_a'$; $U_a''$) de l'amplificateur de compression, que l'amplificateur de séparation (TV) comporte un troisième amplificateur de transconductance (TK3), des sixième, septième et huitième capacités (C6,C7,C8) et des quatrième, cinquième et sixième interrupteurs du premier type (S14,S15,S16) et des quatrième, cinquième et sixième interrupteurs du second type (S24,S25,S26), que le quatrième interrupteur du premier type (S14) est branché entre le multiplicateur fonctionnant sur deux quadrants (ZM') et une première borne de la sixième capacité (C6), que le quatrième interrupteur du second type (S24) est branché entre la première borne de la sixième capacité (C6) et la masse (GND), qu'une seconde borne de la sixième capacité (C6) est reliée à une première borne du troisième amplificateur à transconductance (TK3) et que le cinquième interrupteur du premier type (S4) et le cinquième interrupteur du second type (S25), qui sont reliés entre eux en série, sont branchés entre la seconde borne de la sixième capacité (C6) et la masse (GND), le cinquième interrupteur du second type (S25) étant raccordé à la masse (GND), qu'une sortie du troisième amplificateur à transconductance (TK3) forme une sortie de l'amplificateur de séparation (TV) et est couplée par réaction, par l'intermédiaire de la septième capacité (C7) à une prise médiane située entre le cinquième interrupteur du premier type (S15) et le cinquième interrupteur du second type (S25), que le sixième interrupteur du premier type (S16) et le sixième interrupteur du second type (S26) sont branchés en série entre la masse (GND) et la sortie du troisième amplificateur à transconductance (TK3), le sixième interrupteur du premier type (S16) étant relié à la masse (GND), et qu'une première borne de la huitième capacité (C8) est reliée à une prise médiane située entre le sixième interrupteur du premier type (S16) et le sixième interrupteur du second type (S26) et qu'une seconde borne de la huitième capacité (C8) est raccordée à la première entrée du troisième amplificateur à transconductance (TK3), et qu'une seconde entrée du troisième amplificateur à transconductance (TK3) est relié à la masse (GND).

**17.** Amplificateur à compression suivant la revendication 14 ou 15, caractérisé par le fait que les interrupteurs du premier type et les interrupteurs du second type représentent des portes de transmission et sont commandés au moyen d'une cadence biphasée et que les interrupteurs du troisième type sont réalisés sous la forme d'interrupteurs de marche/arrêt programmables.

**18.** Amplificateur de compression suivant l'une des revendications précédentes, caractérisé par le fait que les transistors à effet de champ du premier type sont des transistors à effet de champ à canal n et que les transistors à effet de champ du second type sont des transistors à effet de champ à canal p et que le premier point de référence est relié à une tension d'alimentation négative et que le second point de référence est relié à une tension d'alimentation positive.

**19.** Utilisation d'un amplificateur de compression selon l'une des revendications précédentes, caractérisé par le fait qu'il est utilisé dans des appareils de correction auditive placés derrière l'oreille, et dans lesquels une gamme dynamique limitée est compensée.

## FIG 1

## FIG 2

FIG 3

FIG 4

FIG 5

## FIG 6

## FIG 7

FIG 8

EP 0 363 714 B1

FIG 9